# EUROPEAN PATENT APPLICATION

(11) **EP 1 437 774 A2**
(43) Date of publication of application: **14.07.2004**
(21) Application number: 03029629.7
(22) Date of filing: 22.12.2003
(51) Int. Cl.: H01L 29/788, H01L 27/115

(54) **Transistor storing multiple bits and method of manufacturing semiconductor memory including the same**

(30) Priority: 07.01.2003 JP 2003001189
(71) Applicant: Innotech Corporation, Yokohama-shi, Kanagawa-ken 222-8580 (JP)
(72) Inventor: Miida, Takashi, Yokohama Kanagawa, 222-8580 (JP); Ichinose, Hideo, Youkaichi-shi, Shiga 527-0038 (JP)
(74) Representative: Grünecker, Kinkeldey, Stockmair & Schwanhäusser Anwaltssozietät

(57) **Abstract**

A flash memory includes a pair of floating gates (FG1, FG2) formed on opposite side walls (13b) of a projection (13a) and each facing one side wall (13b) and one source/drain region (BL1, BL2) via a tunnel insulation layer (15a). The floating gates (FG1, FG2) each have a substantially square cross-section in a direction perpendicular to the direction of column. The square cross-section faces one of the side walls (13b) of the projection (13a) via the tunnel insulation layer (15a) at,one of two continuous sides, faces the source/drain region (BL1, BL2) via the tunnel insulation layer (15a) at the other side, and faces a control gate (CG) via an inter-polycrystalline insulation layer (15b) at another side.

## Description

### BACKGROUND OF THE INVENTION

### Field of the Invention

The present invention relates to a transistor, a semiconductor memory including the same, and a method of manufacturing a transistor. More particularly, the present invention relates to a technology useful for a semiconductor memory having storage cells each storing multiple bits.

### Description of the Background Art

Today, nonvolatile memories including EEPROMs (Electrically Erasable Programmable Read-Only Memories) are widely applied to, e.g. mobile telephones. An EEPROM, for example, usually allows only one bit of information to be stored in each storage cell transistor. However, to promote size reduction of the device, there should preferably be implemented the multiple-bit configuration of a cell transistor that allows two or more bits of information to be stored in the cell transistor.

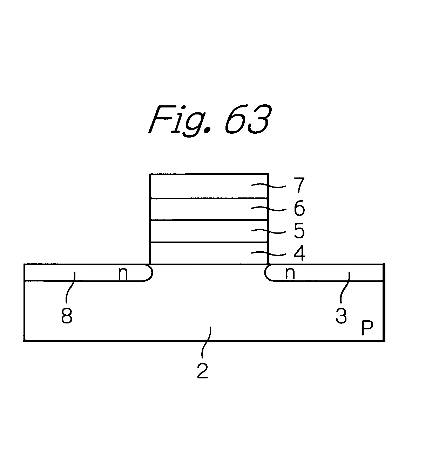

FIG. 63 of the drawings shows a storage cell transistor with a multiple-bit configuration taught in US Patent No. 6,011,725 by way of example. As shown, the cell transistor, generally 1, has a so-called MONOS (Metal Oxide Nitride Oxide Semiconductor) structure made up of a control gate electrode (metal) 7, a silicon oxide layer (oxide) 6, a silicon nitride layer (nitride) 5, a silicon oxide layer (oxide) 4, and a P type silicon substrate (semiconductor) 2 in the order.

In the cell transistor 1, N type source/drain regions 3 and 8 each selectively become a source or a drain electrode at various stages of a write-in or a read-out sequence. In other words, it is indefinite which of the source/drain regions 3 and 8 functions as a source or a drain electrode. In the following description, one of the source/drain regions 3 and 8 that discharges an electric carrier, which may be electrons in this specific case, and the other region will be referred to as a source and a drain region, respectively.

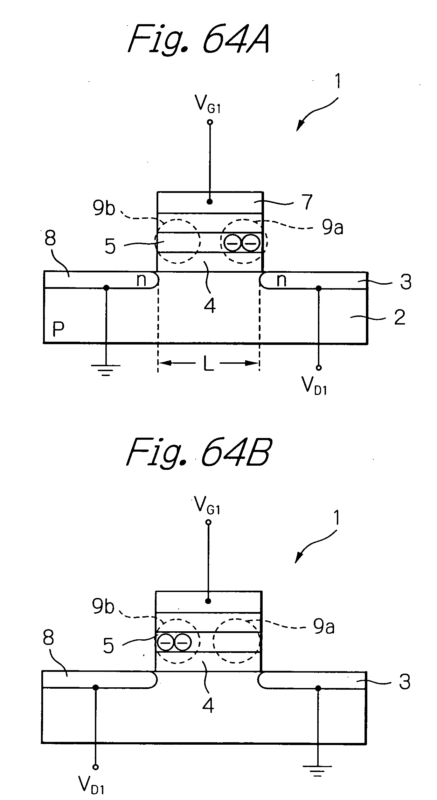

FIG. 64A demonstrates how data is written to the storage cell transistor 1. As shown, the source region 8 is grounded while suitable positive voltages V_{D1} and V_{G1} are applied to the drain region 3 and the control gate 7, respectively. In this condition, an electric field is established between the source region 8 and the drain region 3 and accelerates electrons, so that hot electrons are generated in the vicinity of the drain region 3. The hot electrons thus generated are injected into the silicon nitride layer 5 over the potential barrier formed by the silicon oxide layer 4 due to the collision thereof against phonons and the positive potential of the control gate electrode 7. Because the silicon nitride layer 5 is not electrically conductive, the hot electrons inj ected into the silicon nitride layer 5 localize in the vicinity of the drain region 3, forming a right bit 9a of information stored. This storage condition is representative of a stored-bit state (1, 0).

FIG. 64B shows a condition wherein the source and drain voltages of FIG. 64A are replaced with each other. As shown, the hot electrons injected into the silicon nitride layer 5 localize in the vicinity of the drain region 8, forming a left bit 9b of information stored. This sets up a storage state (0, 1).

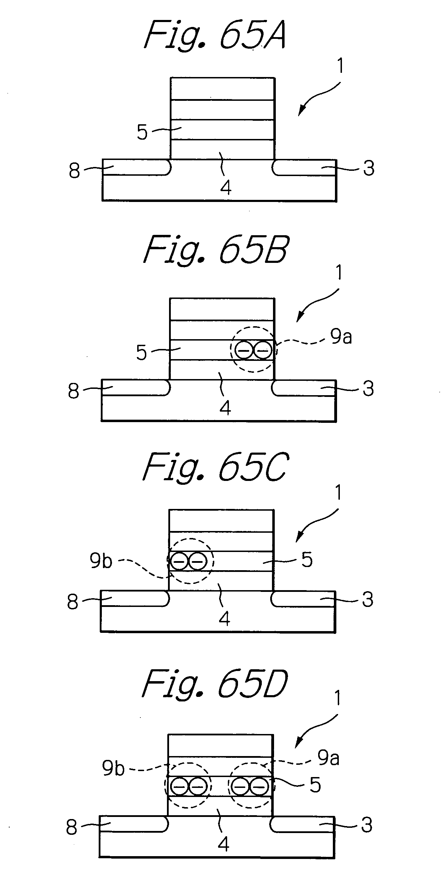

FIGS. 65A through 65D show four different logical storage states available with the cell transistor 1. As shown in FIG. 65A, when electrons are not stored in either one of the right and left bit positions 9a and 9b, a state (1, 1) is set up. As shown in FIG. 65D, when electrons are stored in both of the right and left bit positions, a state (0, 0) is set up. In this manner, the cell transistor 1 allows two-bit data to be stored therein. To read out the data from the cell transistor 1, the voltages applied to the source region 8 and drain region 3 are replaced with each other to measure a drain current two times while each drain current measured is compared with a reference current value, as will be described more specifically hereinafter.

In the state (0, 0) shown in FIG. 65D, electrons localize at both of the right and left bit positions 9a and 9b, so that the potential of the silicon nitride layer 5 is lowest among the four states. Consequently, the threshold voltage of the cell transistor 1 becomes highest and causes substantially no drain current to flow. The value of the drain current remains the same even when the voltages applied to the source region 8 and drain region 3 are replaced, and is almost zero. As a result, the drain currents sequentially measured both are determined to be smaller than the reference current.

In the state (1, 1) shown in FIG. 65A, electrons are absent from both of the right and left bit positions 9a and 9b, so that the potential of the silicon nitride layer 5 is highest among the four states. Therefore, the threshold voltage of the transistor 1 becomes lowest among the four states, causing the greatest drain current to flow. The value of the drain current remains the same even when the source region 8 and drain region 3 are replaced with each other, and is greatest among the four states. As a result, the drain currents measured one after the other are both determined to be greater than the reference current.

On the other hand, in the states (1, 0) and (0, 1) shown in FIGS. 65B and 65C, respectively, electrons localize at only one of the right and left bit positions 9a and 9b, making the cell transistor 1 asymmetrical in the right-and-left direction with respect to potential distribution. The drain currents sequentially measured are different from each other when the voltages applied to the source region 8 and drain region 3 are replaced. It is therefore possible to distinguish the states (1, 0) and (0, 1) by determining which of the two drain currents sequentially measured is greater or smaller than the reference current.

However, the cell transistor 1 with the structure described above has some problems left unsolved, as will be described hereinafter. First, in the event of write-in, see FIGS. 65A and 65B, to allow hot electrons to be injected into the silicon nitride layer 5, the high voltage V_{G1} must be applied to the control gate 7. More specifically, for the injection of hot electrons, it is necessary to tunnel hot electrons from the conduction band of the silicon substrate 2 to the conduction band of the silicon oxide layer 4. An energy difference between the.above two conduction bands is about 3 . 2 electron volts (eV) . However, the hot electrons lose energy on colliding against phonons present in the silicon substrate 2 and cannot be tunneled between the two conduction bands mentioned above even if a voltage of 3.2 volts (V) is applied to the control gate 7. In practice, therefore, the voltage V_{G1} applied to the control gate 7 must be as high as 12 V to 13 V.

While the above high voltage is expected to be applied to the control gate 7 from a highly voltage-resistant transistor included in a decoder circuit, not shown, such a transistor cannot be miniaturized because miniaturization would cause punch-through to occur between the source and the drain electrode of the transistor. It is therefore impossible with the prior art structure described above to reduce the chip size of the entire EEPROM including the decoder circuit.

Second, the current window for distinguishing the drain currents is smaller when the state (1, 0) or (0, 1) is sensed. A current window refers to a difference between the drain currents measured one after the other by replacing the voltages applied to the source and drain regions 3 and 8 in the event of sensing the states (1, 0) and (0, 1). The current window definitely opens when electrons distinctly localize at the right end or the left end of the silicon nitride layer 5, i.e. when the cell transistor 1 is clearly asymmetrical in the right-and-left direction in potential or electron distribution.

Asymmetry, however, does not clearly appear in the cell transistor 1 because electrons are distributed in the silicon nitride layer 5 over some breadth. Particularly, when a gate length L, see FIG. 64A, is reduced for reducing the cell size, it is not clear at which of the right and left bit positions electrons localize, further reducing the asymmetry of the cell transistor 1 and therefore the current window. Such a small current window reduces the margins of the drain and reference currents and thereby aggravates incorrect identification of stored data.

### SUMMARY OF THE INVENTION

It is an object of the present invention to provide a multiple-bit transistor capable of writing data with a reduced voltage with an increased current window, a semiconductor memory including such a multiple-bit transistor, and a method of manufacturing such a semiconductor memory.

A transistor of the present invention includes a one-conductivity type semiconductor substrate formed with a projection having a pair of side walls facing each other. A first insulation layer is formed on the top of the projection. A pair of counter-conductivity type source/drain regions are formed on the surface of the semiconductor substrate at both sides of the projection. Second insulation layers each cover one of the side walls and one of the source/drain regions adjoining the side wall. A pair of floating gates are respectively formed on the side walls of the projection and respectively face the side walls and source/drain regions via the respective second insulation layers. Third insulation layers each are formed on the floating gates. A control gate faces the floating gates via the third insulation layers and faces the top of the projection via the first insulation layer. The floating gates each have a substantially square section that faces one side wall of the projection via one second insulation layer at one side, faces one source/drain region via the second insulation layer at another side, and faces the control gate via one third insulation layer at another side.

A method of manufacturing a transistor of the present invention begins with the step of forming a plurality of trenches in the primary surface of a one-conductivity type semiconductor substrate to thereby form a plurality of proj ections each having a pair of side walls that face each other. A counter-conductivity type impurity is implanted in the bottoms of the trenches to thereby form source/drain regions on the bottoms. Second insulation layers are formed on the source/drain regions and the side walls of each of the projections. Floating gates, each having a substantially square section, are formed on the side walls of the projection and source/drain regions via the second insulation layers. Subsequently, a fourth insulation layer is formed between the floating gate formed on one side wall of one of the projections, which adjoin each other, and the floating gate formed on the side wall of the other projection. Finally, third insulation layers are formed on the fourth insulation layer and floating gates, and then a control gate is formed on the third insulation layers.

### BRIEF DESCRIPTION OF THE DRAWINGS

The objects and features of the present invention will become more apparent from consideration of the following detailed description taken in conjunction with the accompanying drawings in which:
FIG. 1 is a fragmentary perspective view of a semiconductor memory embodying the present invention;
FIG. 2 shows an enlarged section of one of cell transistors included in the semiconductor memory of FIG. 1;
FIG. 3 shows an equivalent circuit representative of the cell transistor of FIG. 2;
FIG. 4 shows a section demonstrating a write mode for writing data in the cell transistor of FIG. 2;
FIG. 5 shows a section of the cell transistor of FIG. 2 provided with a high-resistance region on the top of a projection;
FIGS . 6A through 6D are sections showing four different storage states achievable with the cell transistor of FIG. 2;
FIGS. 7A and 7B are sections showing a read mode for reading out data from the cell transistor of FIG. 2;
FIGS. 8A and 8B show sections useful for understanding how a state (1, 0) is sensed from the cell transistor of FIG. 2;
FIG. 9 shows a section useful for understanding a specific method of discharging electrons implanted in floating gates that form part of the cell transistor;
FIG. 10 shows a section useful for understanding another specific method of discharging electrons implanted in the floating gates;
FIG. 11 shows a section of the cell transistor of the illustrative embodiment with the boron concentration distribution of a projection shown in connection therewith;
FIG. 12 is a block diagram schematically showing the general configuration of the semiconductor memory of FIG. 1;
FIG. 13 is a perspective view showing the semiconductor memory having the configuration of FIG. 12;
FIG. 14 is an enlarged section showing an S type memory available with the illustrative embodiment;
FIG. 15 is a view similar to FIG. 14, showing an L type memory also available with the illustrative embodiment;
FIGS. 16A through 35 are sections demonstrating a series of steps of manufacturing the semiconductor memory of FIG. 1;
FIGS. 36A through 48 are sections demonstrating a series of steps of manufacturing the semiconductor memory of FIG. 14;
FIG. 49 is an enlarged fragmentary section showing a specific configuration of the corner of a trench;
FIGS. 50A through 62 are sections showing a series of steps of manufacturing the semiconductor memory of FIG. 15;
FIG. 63 is a section showing a conventional multi-bit cell transistor;
FIGS. 64A and 64B are sections for describing a write mode particular to the cell transistor of FIG. 63;
FIGS. 65A through 65D are sections showing four storage states available with the cell transistor of FIG. 63;
FIG. 66 is a table listing specific voltages assigned to source/drain regions and control gate included in the S type memory of the illustrative embodiment in a write mode, a read mode and a delete mode; and
FIG. 67 is a table listing specific voltages assigned to source/drain regions and control gate included in the L type memory of the illustrative embodiment in a write mode, a read mode and a delete mode

### DESCRIPTION OF THE PREFERRED EMBODIMENTS

Preferred embodiments of the semiconductor memory in accordance with the present invention will be described with reference to the accompanying drawings hereinafter. It is to be noted that structural elements not directly relevant to the understanding of the present invention are not shown or will not be described. Signals are designated by reference numerals attached to connect lines on which they appear.

To better understand the illustrative embodiment, the principle of operation of cell transistors included in the semiconductor memory and circuitry constituted by the cell transistors will be described first.

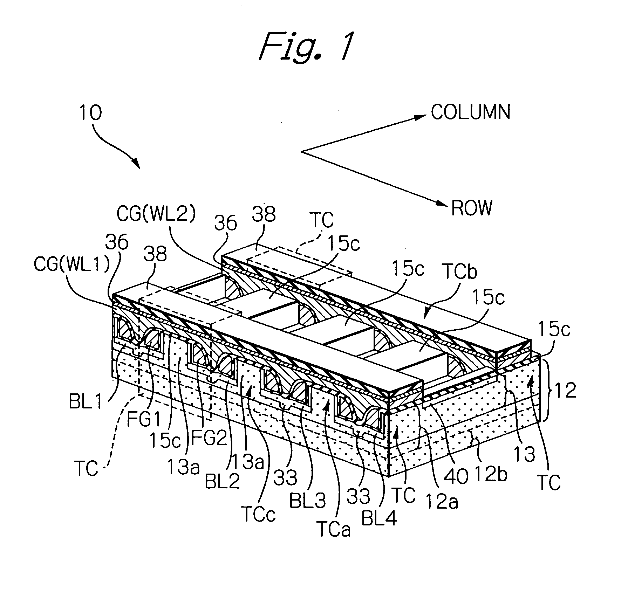

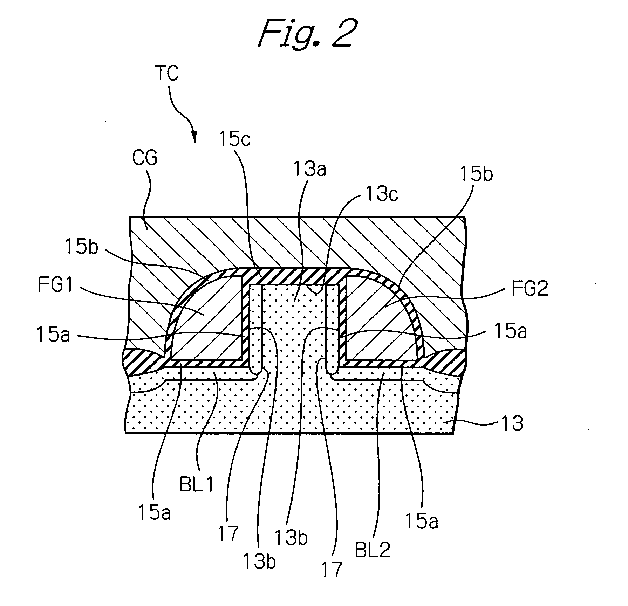

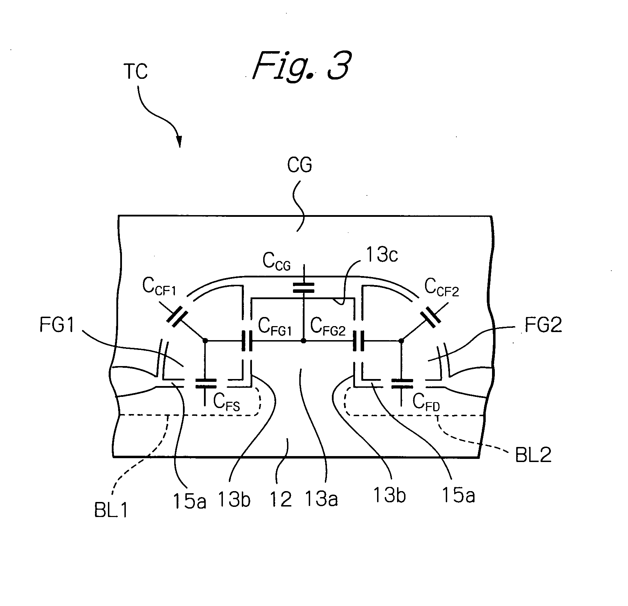

FIG. 1 shows part of a semiconductor memory 10 embodying the present invention. As shown, the semiconductor memory 10 is formed on a P type silicon substrate 12, which is a one-conductivity type semiconductor substrate. The P type silicon substrate 12 is made up of a P⁺ type substrate 12b and a P type epitaxial layer 12a formed on one primary surface of the P⁺ type substrate 12b. A P type well 13 is formed in the P type epitaxial layer 12a.

A plurality of proj ections or ridges 13a protrude from the primary surface of the P type silicon substrate 12. Bit lines BL1 through BL4 are formed on the surface of the P type well 13 at both sides of the proj ections 13a. More specifically, ions of an N type impurity, opposite in conductivity type to the P type well 13, are implanted in the surface of the P type well 13 at positions expected to form the bit lines BL1 through BL4. The bit lines BL1 through BL4 are arranged side by side in the direction of row of the memory cell array while extending in the direction of column each, although hidden by the other structural members and not clearly visible in the figure.

Floating gates FG1 and FG2 and a control gate CG are formed of polycrystalline silicon. More specifically, a plurality of control gates CG are arranged in the direction of column while extending in the direction of row each. The control gates CG respectively play the role of word lines WL1, WL2 and so forth. Insulation layers 36, formed of silicon oxide, each serve to protect particular one of the control gates CG while Al (aluminum) lines 38 each lower the resistance of particular one of the control gates CG.

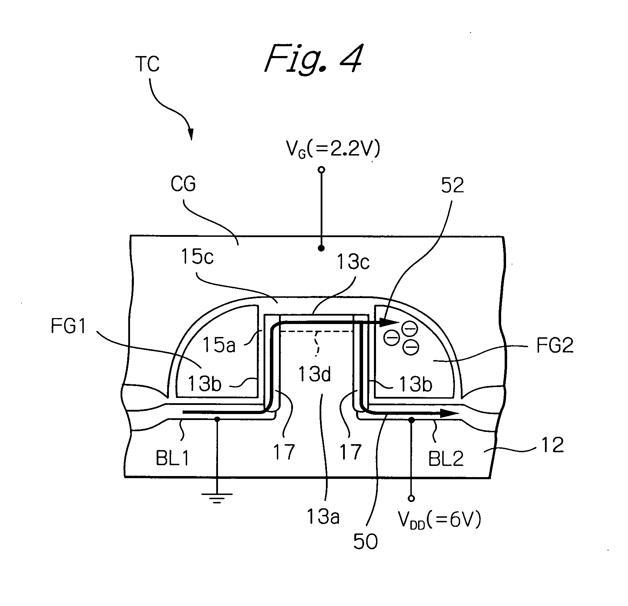

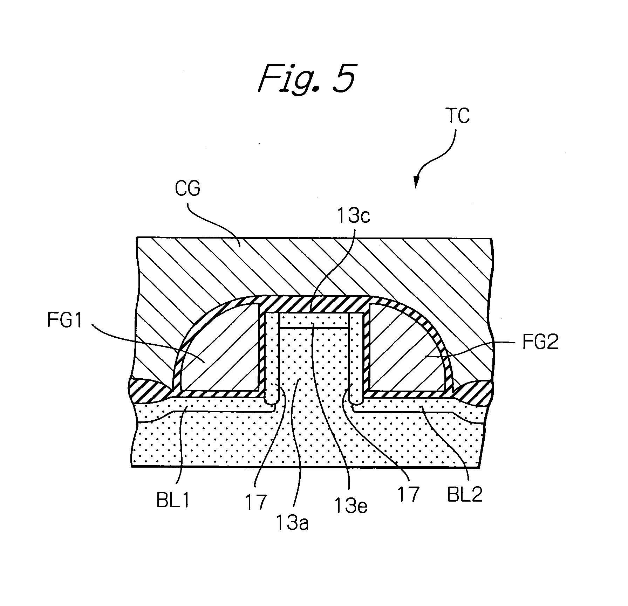

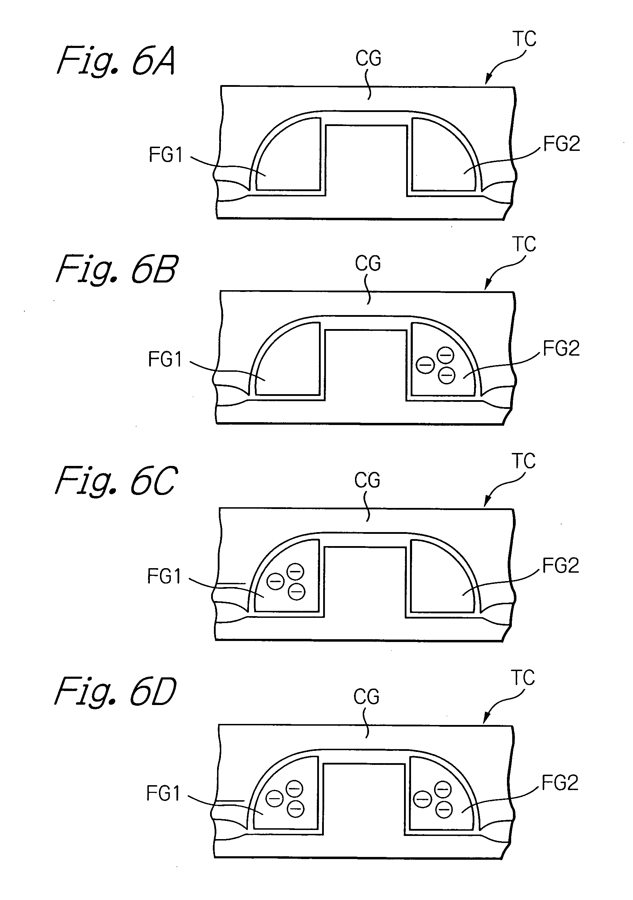

FIG. 2 is an enlarged view showing a cell transistor TC. As shown, the cell transistor TC includes the previously mentioned projection 13a and a gate insulation layer or first insulation layer 15c formed on the top 13c of the projection 13a. The projection 13a has a pair of side walls 13b opposite to each other on which formed are counter-conductivity type, N type, regions 17 opposite in conductivity type to the projection 13a. The impurity concentration of the N type regions 17 is selected to fall between 1/100 and 1/0000, preferably 1/1000, as high as that of the bit lines BL1 and BL2. Tunnel insulation layers or second insulation layers 15a respectively cover one of the side walls 13a and bit line BL1 and the other side wall 13b and bit line BL2. The bit lines BL1 and BL2 bifunction as source/drain regions, as will be described specifically later. In this sense, the bit lines BL1 and BL2 will be sometimes referred to as source/drain regions.

The floating gates FG1 and FG2 respectively face the source/drain regions BL1 and BL2 and the opposite side walls 13b of the projection 13a via the tunnel insulation layers 15a adjoining them. Inter-polycrystalline insulation layers or third insulation layers 15b each are formed on one of the floating gates FG1 and FG2. In the specific configuration shown in FIG. 2, the inter-polycrystalline insulation layers 15b and gate insulation layers 15c each are implemented as a laminate of a silicon oxide layer and a silicon nitride layer. The tunnel insulation layers 15a are formed of silicon oxide.

The control gate CG at least partly faces the floating gates FG1 and FG2 via the inter-polycrystalline insulation layers 15b and partly faces the top 13c of the projection 13a via the gate insulation layer 15c. Alternatively, the control gate CG may comprise segments facing the floating gates FG1 and FG2 with the inter-polycrystalline insulation layer 15b intervening in between and a segment facing the top surface 13c with the gate insulation layer 15c intervening in between, those segments being electrically separate from and electrically controlled independently of each other.

In the structure shown in FIG. 2, a channel region is formed on the surface layers of the opposite side walls 13b and top 13c of the projection 13a in a tridimensional configuration. This is contrastive to a conventional channel region which was formed in a single plane. Therefore, the cell transistor TC achieves a longer channel length while occupying a minimum of area and can therefore reduce the size of a memory device.

The P type impurity of the projection 13a has a concentration adj usted such that the cell transistor TC normally remains in its non-conductive or OFF state. More specifically, assume a condition wherein a preselected voltage is applied to the source/drain region BL1 or BL2 . Then, the concentration of the P type impurity is adjusted such that when a potential difference between the so biased source/drain region BL1 or BL2 and the control gate CG is lower than a threshold voltage the channel region established in the vicinity of the top surface 13c of the ridge 13a in response to the control gate CG through the gate insulation layer 15c goes to its non-conductive state to resultantly render the cell transistor TC non-conductive, or when the potential difference is equal to or higher than the threshold voltage the transistor TC goes conductive. It is to be noted that the preselected voltage applied to the source/drain region BL1 or BL2 refers to a voltage V_{DD} necessary for write-in, read-out and other various operations, as will be described later in detail.

FIG. 3 shows an equivalent circuit representative of the cell transistor TC and including various capacitance associated therewith. The capacitance is represented by a capacitor C_{CG} between the control gate CG and the top 13c of the projection 13c facing each other, a capacitor C_{CF1} (C_{CF2}) between the control gate CG and the floating gate FG1 (FG2) facing each other, a capacitor C_{FG1} (C_{FG2}) between the floating gate FG1 (FG2) and the side wall 13b of the projection 13a facing each other, and a capacitor C_{FS} (D_{FD}) between the floating gate FG1 (FG2) and the source/drain region BL1 (BL2) facing each other.

Referring again to FIG. 1, a plurality of cell transistors TC are arranged side by side in both of the directions of column and row. The cell transistors TC adjoining each other in the direction column, e.g. cell transistors TCₐ and TC_{b} share the source/drain regions BL3 and BL4, but are electrically isolated from each other by an isolation region 40. On the other hand, cell transistors TC_{c} and TCₐ, for example, adj oining each other in the direction of row share the control gate CG and share the source/drain region BL3 between them.

A method of driving the individual cell transistor TC will be described hereinafter. First, reference will be made to FIG. 4 for describing how two-bit data is written into the cell transistor TC. In the illustrative embodiment, electrons can be selectively injected into either one of the floating gates FG1 and FG2, which are positioned at opposite sides of the projection 13a. As shown in FIG. 4, to inject electrons into the right floating gate FG2 in the figure by way of example, a gate voltage V_{G} of, e.g. 2.2 V is applied to the control gate CG while a voltage V_{DD} of, e.g. 6 V, higher than the gate voltage, is applied to the source/drain region BL2 into which electrons should be injected. At the same time, the substrate 12 and the other source/drain region BL1 are grounded.

In the condition shown in FIG. 4, the positive potential applied to the control gate CG causes an inversion layer 13d to be formed in the surface of the top 13c of the projection 13c. The inversion layer 13d thus appearing causes the N type regions 17 to be electrically interconnected to each other. Because the N type regions 17 each are contiguous with one of the N type source/drain regions BL1 and BL2, the N type source/drain regions BL1 and BL2 themselves are electrically interconnected. Consequently, a carrier, electrons in FIG. 4, flows through a path indicated by arrows 50 and 52.

Paying attention to electrons flowing along the top 13c, among others, the floating gate FG2 is positioned just at the right-hand side in the direction of the flow in the figure. Those electrons can therefore be inj ected straightforward into the floating gate FG2 without being steered as in the conventional structure. This allows the gate voltage (write voltage) V_{G} for attracting the electrons toward the floating gate FG2 to be made lower than the conventional gate voltage. In addition, the floating gate FG2 is lowered in potential by the drain voltage through the gate insulation layer 15a having larger capacitance. That allows the gate voltage, or write voltage, V_{G}, for attracting the electrons towards the floating gate FG2, to be lowered to a further extent.

Further, the N type regions 17 formed on the side walls 13b of the projection 13a serve to lower the resistance of the side walls 13b for thereby obstructing voltage drop across the side walls 13b. Consequently, a higher voltage slightly lower than a voltage of, e.g. 6 V between the source/drain regions BL1 and BL2 is applied to the opposite ends of the top 13c; causing the top 13c to forcibly accelerate the electrons. As a result, the electrons are efficiently injected into the floating gate FG2, as indicated by the arrow 52 in FIG. 4. In this manner, the N type regions 17 also serve to lower the write voltage V_{G}. The N type regions 17 have the impurity concentration selected lower than that of the source/drain regions by the order of 1/100 through 1/10000, preferably 1/1000.

The above advantage is achievable even when the channel resistance at the top 13c is increased. The channel resistance can be increased if the thickness of the gate insulation layer 15c is increased to reduce the capacitance between the control gate CG and the channel region. In the illustrative embodiment, as shown in FIG. 4, the gate insulation layer 15c is made thicker than the tunnel insulation layers 15a for such a purpose.

FIG. 5 shows another specific structure for increasing the channel resistance at the top 13c. As shown, a high-resistance region 13e, which is a one-conductivity type of impurity-doped region, is formed on the top 13c of the projection 13a. To form the high-resistance region 13e, ions of a P type impurity are implanted in the top 13c to a higher concentration than that of the projection 13a.

When the channel resistance at the top 13c is increased, as shown in FIG. 4 or 5, the voltage drop at the top 13c increases with the result that a higher voltage slightly lower than the voltage between the source/drain regions BL1 and BL2 is applied to the opposite ends of the top 13c. Consequently, there can be lowered the write voltage V_{G} for the same reason as stated above.

As stated above, the write voltage V_{G} can be lowered i) if the N type regions are formed on the side walls 13b, ii) if the tunnel insulation layer has an increased capacitance to raise the floating gate in potential with the drain voltage, iii) if the thickness of the gate insulation layer 15c is increased, or iv) if the high-resistance region 13e is formed on the top 13c. These different schemes i) through iv) may be suitably combined, if desired, to attain the intended advantages described above. In any case, the write voltage V_{G} should only be about 2.2 V, which is far lower than the conventional write voltage of about 12 V to 13 V.

With the example shown in FIG. 4, electrons are inj ected into the right floating gate FG2. Into the left floating gate FG1, however, electrons can be injected only if the voltages applied to the source/drain regions BL1 and BL2 are replaced with each other from the FIG. 4 example. The illustrative embodiment therefore implements four different states shown in FIGS. 6A through 6D. FIG. 6A shows a stored-bit state (1, 1) in which electrons are not injected into either one of the floating gates FG1 and FG2. FIGS. 6B and 6C respectively show storage states (1, 0) and (0, 1) in each of which electrons are injected into either one of the floating gates FG1 and FG2. FIG. 6D shows a state (0, 0) in which electrons are injected into both of the floating gates FG1 and FG2; for example, electrons may be injected into the right floating gate FG2 and then inj ected into the left floating gate FG1. In this manner, the illustrative embodiment allows two bits of data (1, 1) through (0, 0) to be selectively written to a single cell transistor TC.

The illustrative embodiment includes two floating gates FG1 and FG2 and allows electrons to exist in the gates FG1 and FG2 separately from each other, as stated above. Therefore, even in an application in which the cell size is reduced, it is definitely distinguishable which of the floating gates FG1 and FG2 includes significant electrons, compared to the prior art structure.

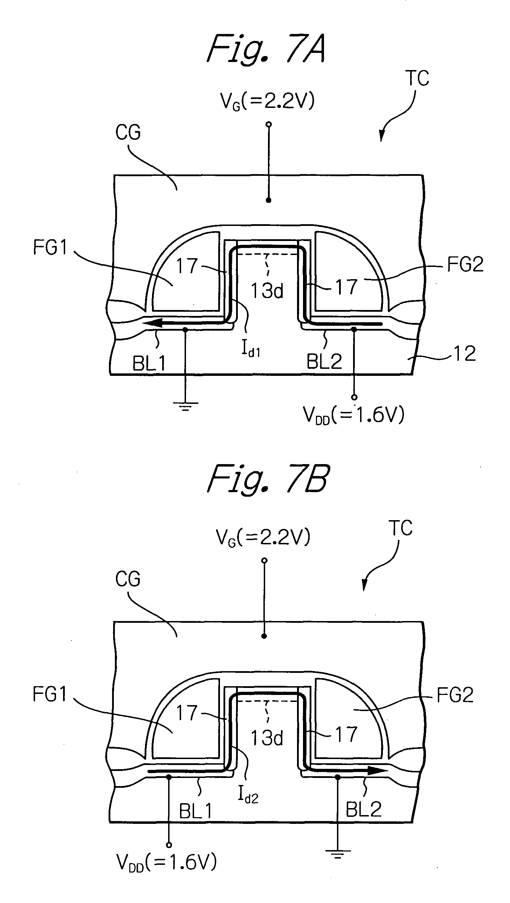

Reference will be made to FIGS. 7A and 7B for describing how two-bit data are read out from the individual cell transistor TC. First, as shown in FIG. 7A, the gate voltage V_{G} of, e.g. 2.2 V is applied to the control gate CG. Subsequently, the voltage V_{DD} of, e.g. 1.6 V is applied to one source/drain region BL2 while the other source/drain region BL1 and substrate 12 are connected to ground, i.e. a reference potential. In the resulting potential distribution, the potential of the control gate CG is positive with the result that the inversion layer 13d is formed on the top 13c of the projection 13. As a result, a drain current I_{d1} flows in a direction indicated by an arrow in FIG. 7A.

Subsequently, as shown in FIG. 7B, the voltages applied to the source/drain regions BL1 and BL2 are replaced with each other with the gate voltage V_{G} of 2.2 V being maintained the same. As a result, the potential difference between the source/drain regions BL1 and BL2 is inverted, causing a drain current I_{d2} to flow in a direction indicated by an arrow in FIG. 7B.

In the illustrative embodiments, the drain currents I_{d1} and I_{d2} are measured which flow one after the other due to the replacement of the voltages applied to the source/drain regions BL1 and BL2. The values of the drain currents I_{d1} and I_{d2} are different in accordance with the states, as will be described specifically later. It is therefore possible to compare the current sets (I_{d1}, I_{d2}) with the states one-to-one to determine which of the states the cell is. Drain currents to flow at the different states (1, 1) through (0, 0) will be described in detail hereinafter.

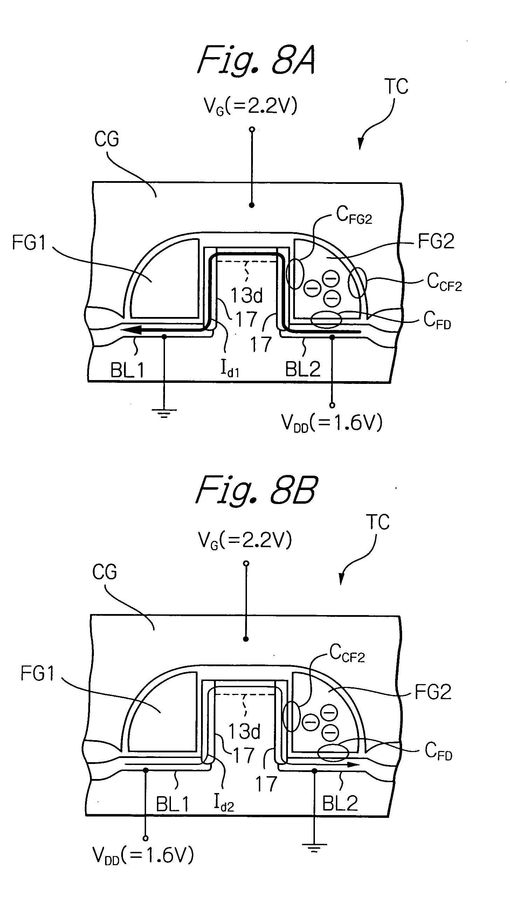

FIGS. 8A and 8B demonstrate how the state (1, 0) is sensed from the cell transistor TC. As shown in FIG. 8A, voltages are applied to the structural members of the cell transistor TC in the same manner as in FIG. 7A, causing the drain current I_{d1} to flow. In this condition, although the potential of the right flowing gate FG2 is lowered due to electron injection, it is raised by the capacities C_{CF2} and C_{FD} toward the positive potential of the control gate CG (2.2 V) and that of the source/drain BL2 (1.6 V). Consequently, the potential drop of the floating gate FG2 is limited, so that channel resistance around the gate FG2 is not so high. The drain current I_{d1} therefore has a relatively great value.

Particularly, the N type region 17 contacting the source/drain region BL2 has a potential substantially equal to the potential of the source/drain region BL2. The potential of the floating gate FG2 is therefore raised toward the source/drain BL side by the capacitance C_{FG2} as well, further lowering channel resistance around the gate FG2. As a result, the value of the drain current I_{d1} further increases.

Subsequently, as shown in FIG. 8B, the voltages applied to the source/drain regions BL1 and BL2 are replaced with each other to cause the drain current I_{d2} to flow. In this case, the potential of the right floating gate FG2 is lowered due to electron injection. Further, because the right source/drain region BL2 is connected to the ground, the potential of the floating gate FG2 is lowered toward the ground through the capacitance C_{FD} between the gate FG2 and the region BL2. Consequently, the potential of the floating gate FG2 is lower in FIG. 8B than in FIG. 8A and causes channel resistance around the gate FG2 to increase. The drain current I_{d2} is therefore smaller than the previous drain current I_{d1.}

Particularly, the N type region 17 causes the potential of the right floating gate FG2 to be lowered toward the ground side by the capacitance C_{FG2} as well, so that the value of the drain current I_{d2} is further reduced. As stated above, the state (1, 0) can be identified on the basis of (I_{d1}, I_{d2}) ₌ (large, small) . To identify greater one of the drain currents I_{d1} and I_{d2}, a sense amplifier associated with the memory circuit, not shown, compares each of them with a reference current.

The values of the drain currents I_{d1} and I_{d2} can be increased or decreased on the basis of the capacitance C_{CF2}, C_{FD} and C_{FG2}, as desired. This allows the difference (I_{d1} - I_{d2}) to be increased to a desired value. Stated another way, the illustrative embodiment allows the current window represented by the above difference to be broadened, as desired. A wide current window increases the margins of the drain currents I_{d1} and I_{d2} and reference current, thereby reducing the probability of incorrect identification of written data.

To sense the state (0, 1) from the cell transistor TC, electrons are inj ected into the left floating gate FG1 opposite to the right floating gate FG2. Therefore, the drain currents I_{d1} and I_{d2} are estimated in the same manner as in the above description, so that there holds (I_{d1,}I_{d2}) = (small, large).

As for the state (1, 1) to be sensed from the cell transistor TC, electrons are not injected into either one of the floating gates FG1 and FG2. In this case, the drain currents I_{d1} and I_{d2} both are great because the potential of the floating gate FG1 or that of the floating gate FG2 is not lowered by the electrons. This condition is symmetrical in the right-and-left direction, i.e. the drain currents I_{d1} and I_{d2} are not different from each other; (I_{d1}, I_{d2}) - (large, large) holds.

Further, as for the state (0, 0), symmetry is set up in the right-and-left direction because electrons are inj ected into both of the floating gates FG1 and FG2. Therefore, (I_{d1,} I_{d2}) = (small, small) holds, meaning that the drain currents I_{d1} and I_{d2} are not different from each other.

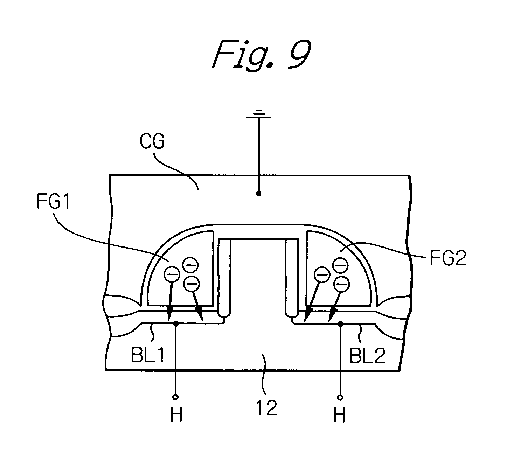

Specific methods of discharging the electrons, i.e. deleting the data stored, injected in the floating gates FG1 and FG2 available with the illustrative embodiment will be described hereinafter. FIG. 9 shows a specific method that withdraws electrons from the floating gates FG1 and FG2 into the source/drain regions BL1 and BL2, respectively. This method is practicable by connecting the control gate CG to ground and applying a high potential "H" (e.g. 12 V) to each of the source/drain regions BL1 and BL2. In this regard, the potential difference may be set up relatively between the control gate CG and the source/drain regions BL1 and BL2. For example, the control gate CG and the source/drain regions BL1 and BL2 may be supplied with a voltage of -6 V and +6 V, respectively.

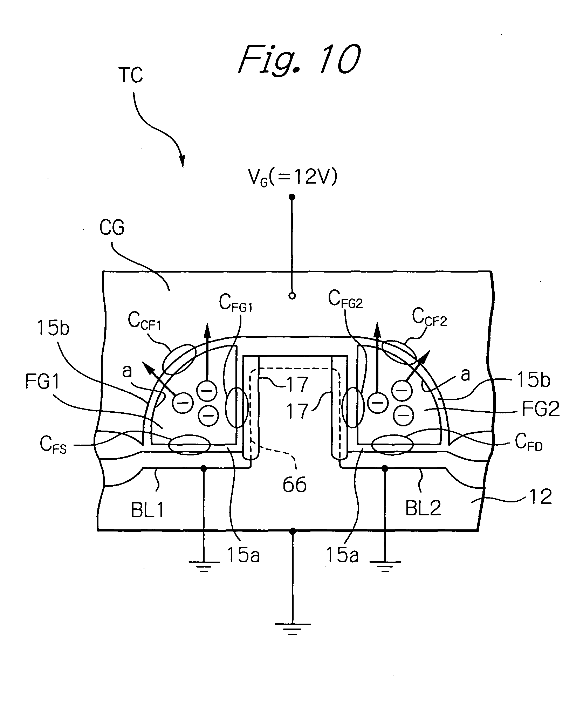

FIG. 10 shows another specific method that applies a high potential V_{G} (e.g. 12 V) to the control gate CG and connects the substrate 12 and source/drain regions BL1 and BL2 to ground. In this potential distribution, electrons are withdrawn from the floating gates FG1 and FG2 into the control gate CG because the potential of the control gate CG is higher than the potentials of the gates FG1 and FG2. In this regard also, the control gate CG and the source/drain regions BL1 and BL2 may be supplied with a voltage of +6 V and -6 V, respectively.

The writing, reading and deleting operations of the illustrative embodiment have been shown and described on the assumption that the cell transistor TC is selected in the memory cell array. In practice, however, the cell transistor TC is sometimes not selected. Even when the cell transistor 1 is not selected, the drive voltage V_{DD} is applied to the bit line BL1, see FIG. 3, in order to select another other cell transistor TC. In this case, the potential of the floating gate FG1 of the unselected cell transistor TC is pulled toward the potential of the bit line BL1 due to a great capacitance C_{FS} between the gate FG1 and the bit line BL1. As a result, the potential difference between the floating gate FG1 and the source/drain region BL1 decreases, so that the tunnel insulation layer 15a between the gate FG1 and the region BL1 is prevented from being exposed to the strong electric field. Consequently, a tunnel current that would deteriorate the tunnel insulation layer 15a is successfully prevented from flowing through the layer 15a.

It is noteworthy that the capacitance C_{FS} (C_{FD}) between the floating gate FG1 (FG2) and the source/drain region BL1 (BL2) plays an important role in achieving the advantages described in relation to write-in, read-out and deletion as well as the unselected condition. In the illustrative embodiment, the floating gate FG1 (FG2) is positioned above the source/drain region BL1 (BL2) in order to reduce the distance between the floating gates FG1 and FG2, thereby reducing the device size and increasing the capacities C_{FD} and C_{FS}.

The area over which the floating gate FG1 (FG2) and source/drain region BL1 (BL2) face each other is open to choice. While the advantages described above are easier to achieve as the above area becomes larger, they are achievable even if the area is small.

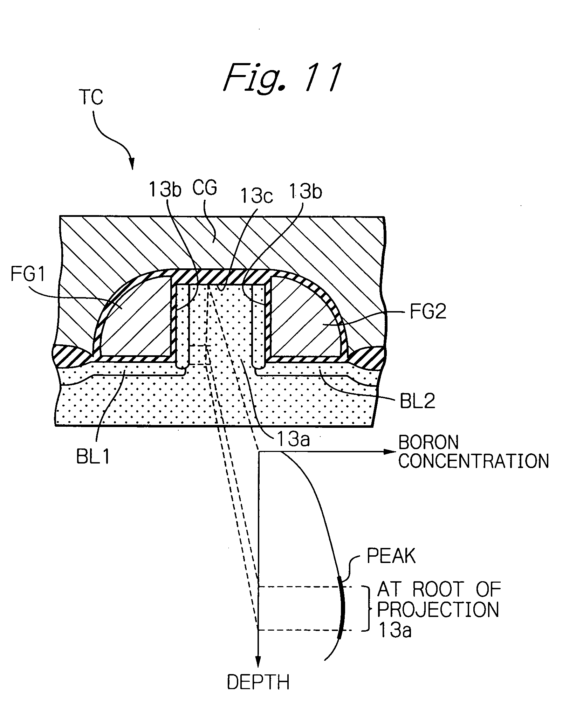

The illustrative embodiment copes with punch-through and stabilizes the threshold voltage Vₜₕ with the following implementations. When punch-through between the source/drain regions BL1 and BL2 is likely to occur, it is preferable to use a specific structure shown in FIG. 11. A graph shown in FIG. 11 together with the specific structure plots the concentration of boron, acting as a P type impurity, with respect to depth in the projection 13a. As shown, the boron concentration of the projection 13a sequentially increases in the direction of depth up to the root portion of the projection 13a. The boron concentration is therefore high on the portions of the side walls 13b adjoining the source/drain regions BL1 and BL2.

The above-described structure is featured with the concentration of the P type impurity higher in the part of an expected channel closer to the N type source/drain regions BL1 and BL2 . The channel will therefore be established apart from the straight line connecting the N type source/drain regions BL1 and BL2. In other words, the channel will be formed in the side wall surfaces 13b and the top surface 13c of the projection 13a. That also implies in the structure shown in FIG. 11 that the concentration of the P type impurity higher in the portions of the channel closer to the N type source/drain regions BL1 and BL2 obviates punch-through between the source/drain regions BL1 and BL2. A higher packing density will be accomplished with a semiconductor memory device integrating the cell transistors in the form of integrated circuit.

The threshold voltage Vₜₕ of the cell transistor TC is noticeably susceptible to the impurity concentration on the portions of the side walls 13b close to the root portion of the projection 13a. It follows that the high boron concentration at the root portion of the proj ection 13a results in a high threshold voltage Vₜₕ. However, the N type impurity of the N type regions 17 formed on the side walls 13b and the P type impurity of the side walls 13b compensate each other, so that the substantial acceptor concentration of the side walls 13b can be lowered. Therefore, even if the boron concentration is increased in the root portion of the projection 13a, the N type regions 17 surely prevent the threshold voltage Vₜₕ from rising to an excessive degree.

Because the threshold voltage Vₜₕ is susceptible to the impurity concentration of the root portion of the projection 13a, as stated above, the impurity concentration of the root portion should preferably be prevented from noticeably varying in order to stabilize the threshold voltage Vₜₕ. For this purpose, it is preferable not only to increase the boron concentration of the projection 13a little by little, but also to make a peak thereof as flat as possible, as indicated by bold part of the curve shown in FIG. 11. In such a flat portion, the boron concentration varies little, so that a relation between the boron concentration and the arsenic concentration of the N type regions 17 remains substantially constant. This is successful to maintain the threshold voltage Vₜₕ stable.

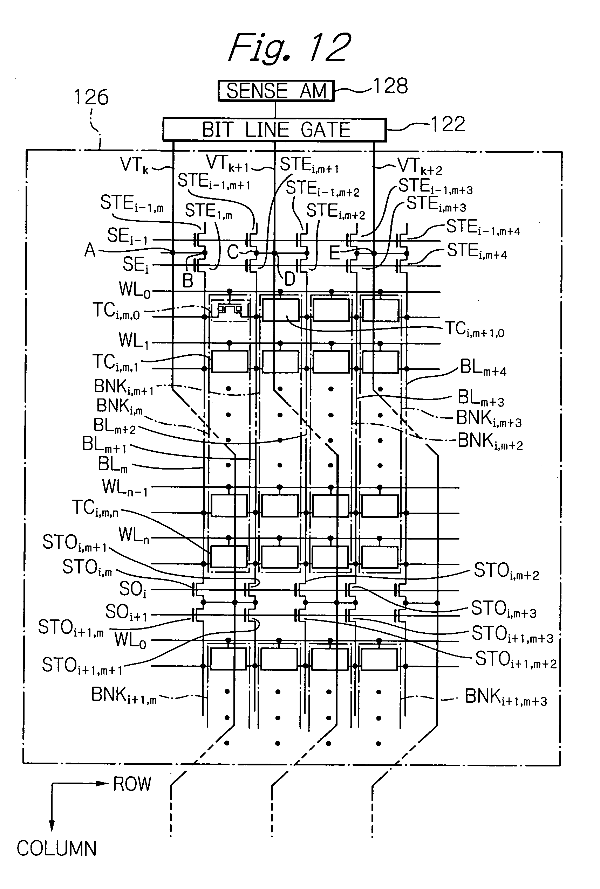

Reference will be made to FIG. 12 for describing the general circuit arrangement of a semiconductor memory array 126 operable with the principle described above. In FIG. 12, a cell transistor TC_{i,m,p} is the p-th (p = 0, 1, 2, ...) cell transistor belonging to a bank BNK_{i,m} on the i-th (i = 0, 1, 2, ...) row and m-th (m = 0, 1, 2, ...) column and configured and operated as described with reference to FIG. 2. The cell transistors TC_{i,j,} each belong to a particular (1 column) x (n rows) bank BNK_{i,m}; n of (n rows) denotes a natural number open to choice while i and m of BNK_{i,m} respectively denote a row number and a column number shared by all of the cell transistors T_{i,j} belonging to the bank BNK_{i,m}.

The semiconductor memory 126 differs from a conventional flash memory in that it does not select a cell transistor by combining a word line and a bit line, but first selects either one of a group of even banks BNK_{i,m} (m = 0, 2, 4, ...) and a group of odd banks BNK_{i,m} (m = 1, 3, 5, ...) on the i-th row via a select line SEᵢ or SO_{I}, then selects one of the group of banks thus selected via a bit line BLₘ (m = 0, 1, 2, ...) , more precisely a virtual ground line VT_{K} connected to the bit line BLₘ, and then selects one of the cell transistors TC_{i,m,p} belonging to the even or the odd bank BNK_{i,m} selected via a word line WLp.

Select transistors STE_{i,m} and STO_{i,m} each are connected to a particular bank BNK_{i,m} for selecting the bank BNK_{i,m}. More specifically, the select transistors STE_{i,m} are used to select, among the banks BNK_{i,m} on the i-th row, even banks BNK_{i,m} (m = 0 , 2, 4, ...) and will sometimes be referred to as even-bank select transistors hereinafter. To designate the select transistors STE_{i,m,} a select line SEᵢ is used. The select transistors STE_{i,m} (m 1, 2, ...) on the i-th row all are connected to a single select line SEᵢ and therefore selected at the same time via the select line SEᵢ.

Likewise, the select transistors STO_{i,m} are used to select, among the banks BNK_{i,m} on the i-th row, odd banks BNK_{i,m} (m = 1, 3, 5, ...) and will sometimes be referred to as odd-bank select transistors hereinafter. To designate the select transistors STO_{i,m,} a select line SOᵢ is used. The select transistors STO_{i,m} (m= 0, 1, 2 , ...) on the i-th row all are connected to a single select line SOᵢ and therefore selected at the same time via the select line SOᵢ.

The even-bank select transistors STE_{i,m} on every other column have one of their source/drain regions interconnected, as illustrated. Virtual ground lines VGₖ (k = 0, 1, 2, ...) each are connected to one of nodes A, D and E where the above source/drain regions are interconnected. This is also true with the odd-band select transistors STO_{i,m} except that nodes where their source/drain regions are interconnected are shifted from the nodes of the even-bank select transistors STE_{i,m} by one column each, as illustrated.

Labeled STE_{i-1,m} (j = 0, 2, ...) are even-bank select transistors each for selecting, among the (i-1)-th banks as counted in the direction of column, an even bank. Also, labeled STO_{i+1,m} (m = 1, 3, ...) are odd-bank select transistors each for selecting, among the (i+1) -th banks as counted in the direction of column, an odd bank.

The virtual ground lines VTₖ(k = 0, 1, 2, ...) are formed of aluminum or similar metal so as to have their electric resistance lowered. On the other hand, bit lines BLₘ (m = 0, 1, 2, ...) are implemented as diffusion layers far higher in electric resistance than the virtual ground lines VTₖ.

The operation of the semiconductor memory 126 shown in FIG. 12 will be described hereinafter. Assume that the cell transistor TCi,m,o should be selected for reading out data, and that m is even, i.e., the cell transistor TC_{i,m,0} concerned belongs to an odd bank BNK_{i,m.} Then, an even-bank select line SEᵢ is caused to go high for selecting a group of even banks BNK_{i,m} (m = 0, 2, 4, ...), thereby turning on the even-bank select transistors STE_{i,m} (m = 0, 1, 2 ...) . At the same time, the other select lines SEᵣ (r = 0, 1, 2, ..., i-1, i+1, ...) and SOᵣ (r = 0, 1, 2, ...) all are caused to go low for thereby turning off all of the transistors whose gates are connected to such select lines. In the resulting voltage distribution, the even-bank select transistors STE_{i,m} and STE_{i,m+1} in an ON state electrically connect the bit lines BLₘ and BLₘ₊₁ to the virtual ground lines VTₖ and VTₖ₊₁, respectively. Likewise, the bit lines connected to the other even banks BNK_{i,m-2,} BNK _{i,m+4} and so forth are brought into electrical connection with the virtual ground lines.

Subsequently, to select the cell transistor TC_{i,m,0,} the virtual ground line VTₖ connected to the cell transistor TC_{i,m,0} via the bit line BLₘ is brought to the ground level while a low voltage VDD of 1.6 V is applied to the virtual ground line VTₖ₊₁ connected to the same cell transistor TC_{i,m,0} via the bit line BL_{m+1.} The other virtual ground lines VTₖ are held in an open state. In this manner, the odd banks BNK_{i,m} (m = 0, 2, 4, ...) are selected. More specifically, the virtual ground lines VTₖ are so set by a bit line gate 122, which will be described later specifically, connected to the virtual ground lines VTₖ. Thereafter, 2.2 V is applied to the word line WL₀. Further, the bit line gate 122 connects only the virtual ground line VTₖ₊₁ to a sense amplifier 128, so that the sense amplifier 128 senses a current flowing through the virtual ground line VTₖ₊₁.

The voltages applied to the source/drain region, as stated above, cause a first drain current I_{d1} to flow through the cell transistor TC_{i,m,0,} as described previously with reference to FIG. 8A. The first drain current I_{d1} sequentially flows from the sense amplifier 128 via bit line gate 122, the virtual ground line VTₖ₊₁, node D, node C, even-bank select transistor SET_{i,m+1,} bit line BLₘ₊₁, cell transistor TC_{i,m,o,} bit line BLₘ, odd-bank select transistor STE_{i;m,} node B, node A, virtual ground line VTₖ, and bit line gate 122 in this order.

Subsequently, the bit line gate 122 inverts the potential difference between the bit lines BLₘ and BLₘ₊₁ while maintaining the other voltages the same. As a result, a second drain current I_{d2} flows through the cell transistor TC_{i,m,0,} as stated with reference to FIG. 8B. The second drain current I_{d2} flows through a route opposite to the route of the first drain current I_{d1.}

The procedure described above allows the sense amplifier 128 to measure the first and second drain currents I_{d1} and I_{d2} flown through the cell transistor TC_{i,m,0} and thereby determine which of the four states " (1, 1)" through " ( 0 , 0 ) " is stored in the cell transistor TC_{i,m,0.}

In the circuitry shown in FIG . 12, the first drain current I_{d1} does not constantly flow through the high-resistance bit lines BLₘ and BLₘ₊₁ implemented as diffusion layers, but flows through the virtual ground line VT_{k+1,} which is formed of aluminum and therefore low in resistance, up to the target bank BNKi,m and then flows through the bit line BL_{m+1.} Subsequently, the drain current I_{d1} flown through the cell transistor TC_{i,m,0} flows through the virtual ground line VTₖ via the bit line BLₘ.

The resistance is therefore lower when the first drain current I_{d1} flows through the above route than when it constantly flows through the bit lines BLₘ and BL_{m+1.} The illustrative embodiment can therefore sense the first drain current I_{d1} as well as the second drain current I_{d2} at high speed.

In the specific procedure described above, the cell transistor TC_{i,m,0,} belonging to the even bank BNK_{i,m,} is selected. On the other hand, to select the transistor TC_{i,m,p} belonging to the odd bank group BNK_{i,m} (m = 1, 3, 5, ...) , the odd-bank select line SOᵢ is caused to go high for thereby turning on the odd-bank select transistors STO_{i,m} (m= 0, 1, 2, ...) . The other select lines SEᵣ (r = 0, 1, 2, ...) and SOᵣ (r = 0, 1, 2, ..., i-1, i+1, ...) are caused to go low, so that the transistors whose gates are connected to those select lines all are turned off. The rest of the procedure is identical with the procedure described in relation to the selection of the even bank and will not be described specifically in order to avoid redundancy. The method of selecting a cell transistor described above is sometimes referred to as a virtual grounding system.

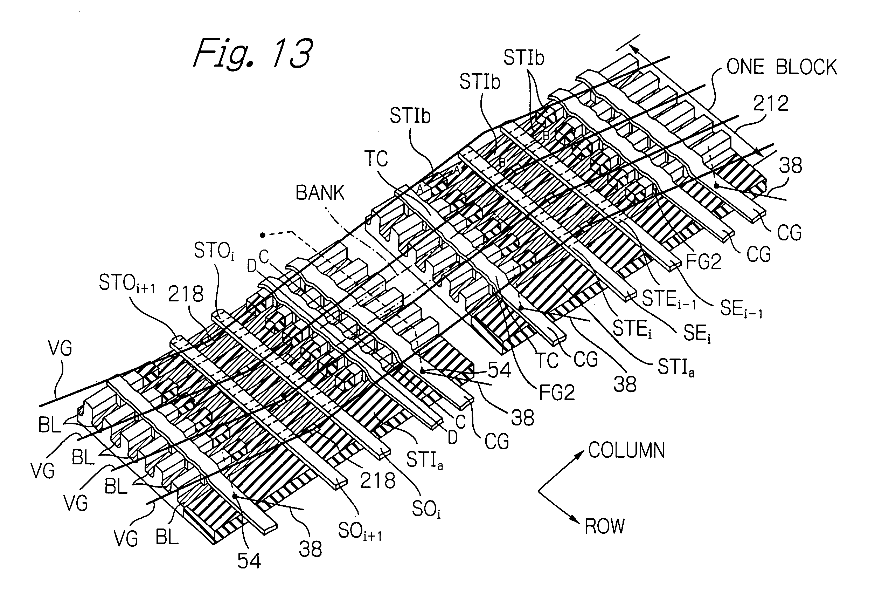

FIG. 13 shows a semiconductor memory using the virtual grounding system. As shown, the semiconductor memory includes device isolation regions STIa in addition to the cell transistors TC, which constitute the banks BANK, for the following reasons.

As shown in FIG . 13, to promote rapid writing and reading , the transistors TC should preferably be divided into a plurality of blocks 212. In this condition, a device isolation region STIa is formed between nearby one of the blocks 212 arranged in the direction of row for isolating them from each other. Each block 212 has, e.g., thirty-two or sixty-four cell transistors TC whose source/drain regions are serially connected in the direction of row. In each block 212 , the control gates CG of a plurality of cell transistors TC are interconnected.

The significance of the device isolation regions STIa will be described more specifically hereinafter. Assume that the sources and drains BL of a plurality of cell transistors TC are connected in series. Then, when data are written to some of those transistors TC at the same time, it is likely that the data are written even to unexpected cell transistors. This problem can be solved if the cell transistors TC are divided into a plurality of blocks 212 by the device isolation regions STIa and if data are allowed to be written only to the cell transistors TC belonging to different blocks 212 at the same time. In addition, this configuration maintains the writing speed high. Further, if data are read out only of the cell transistors TC belonging to different blocks 212 at the same time, then there can be obviated an occurrence that a current flows to the cell transistors TC other than expected one.

The device isolation regions STIa should preferably be implemented as STI (Shallow Trench Isolation) regions that occupy a minimum of area and therefore reduce the overall size of the semiconductor memory.

The semiconductor memory further includes metal wires or conductors 38 formed of, e.g. , aluminum and each connecting the control gates CG of a plurality of cell transistors TC to each other, and contacts 54 each connecting one of the aluminum wires 38 to the associated control gate CG. The contacts 54 may be positioned above the device isolation region STIa. The conductors 38 serve to lower the resistance of the control gates CG. Device isolation regions STIb, which are also provided with the STI structure, are arranged in the direction of column, and each intervenes between nearby banks BNK. The virtual ground lines VT are connected to the bit lines BL at points 218.

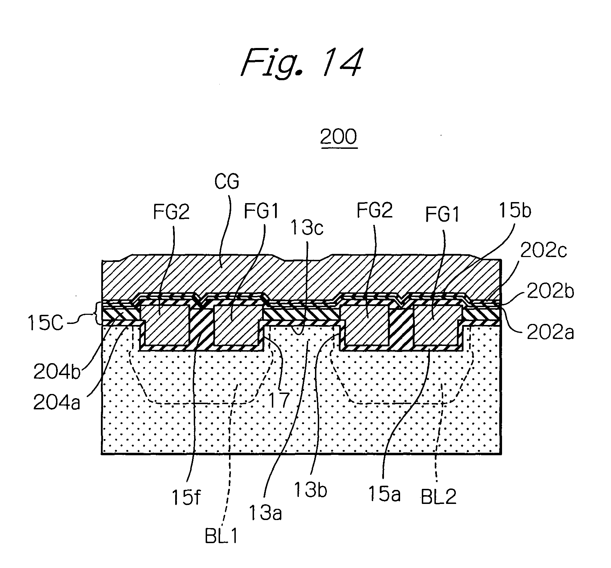

FIG. 14 shows an alternative embodiment of the semiconductor memory in accordance with the present invention including a cell transistor different from the cell transistor TC of FIG. 2 mainly as to the configuration of the floating gates FG1 and FG2. In the illustrative embodiment, the semiconductor memory is implemented as a flash memory. As shown, the flash memory, generally 200, includes the P type semiconductor substrate formed with the projection 13a having opposite side walls 13b, gate insulation layer 15c formed on the top of the projection 13a, N type source/drain regions BL1 and BL2 formed on the surface of the substrate at opposite sides of the proj ection 13a, and tunnel insulation layers 15a covering the side walls 13b and source/drain regions BL1 and BL2. The floating gates FG1 and FG2 face the side walls 13b of the projection 13a and source/drain regions BL1 and BL2 via the tunnel insulation layers 15a. The inter-polycrystalline insulation layers 15b are formed on the floating gates FG1 and FG2. The control gate CG at least partly faces the floating gates FG1 and FG2 via the inter-polycrystalline insulation layers 15b and faces the top 13c of the projection 13a via the gate insulation layer 15c.

The portions of the control gate CG facing the floating gates FG1 and FG2 and the portion of the same facing the top 13c of the projection 13a may be formed electrically independently of each other and electrically controlled independently of each other.

In the illustrative embodiment, the floating gates FG1 and FG2 each are substantially rectangular; as seen in a section perpendicular to the direction of column. One of two sides of the rectangle contiguous with each other faces one side of the projection 13a via the tunnel insulation layer 15a while the other side faces the source/drain region BL1 or BL2 via the tunnel insulation layer 15a. Another side of the rectangle faces the control gate CG via the inter-polycrystalline insulation layer 15b. Because the floating gates FG1 and FG2 each are substantially square , let the memory of the illustrative embodiment be referred to as an S (Square) type memory hereinafter.

In the illustrative embodiment, the inter-polycrystalline insulation layer 15b is implemented as a stack made up of a silicon oxide layer 202a, a silicon nitride layer 202b, and a silicon oxide layer 202c. The gate insulation layer 15c includes, in addition to the layers 202a through 202c, a silicon oxide layer 204a and a silicon nitride layer 204b underlying the layers 202a through 202c.

The silicon oxide layer 204a may be formed by a method customary with a gate insulation layer (thermal oxide layer) . This is also true with the layers 202a through 202c constituting the inter-polycrystalline insulation layer 15b. Further, the layers 202a through 202c are formed after the surfaces of the floating gates FG1 and FG2 facing the control gate CG have been flattened by CMP (Chemical Mechanical Polishing), achieving high breakdown voltage. Should the insulation layer 15b be formed on, e. g. , polycrystalline silicon having a rough surface and used for the floating gates FG1 and FG2, the breakdown voltage of the insulation layer 15b might be lowered to a critical degree. The flash memory 200 of the illustrative embodiment can be produced with a minimum of risk because the individual step is conventional.

It is noteworthy that the square floating gates FG1 and FG2 have a lower coupling ratio CR than the sectorial floating gates FG1 and FG2 shown in FIGS. 1 and 2. A coupling ratio refers to a ratio C_{CF1}/ (C_{FG1} + C_{FS}) or C_{CF2}/ (C_{FG2} + C_{FD}) where CC_{F1}, C_{CF2} and so forth denote the various capacitors stated earlier with reference to FIG. 3. More specifically, the cell transistor shown in FIG. 2 has a coupling ratio CR of about 0.37 while the transistor of the illustrative embodiment achieves a coupling ratio of 0.35 or below, more specifically around 0.32, for the following reason. The floating gates FG1 and FG2 of FIG. 2 each have a generally sectorial shape whose center angle is 90°. By contrast, the floating gates FG1 and FG2 of the illustrative embodiment each have a square shape, so that the contact area with the control gate CG is reduced.

A low capacitance ratio CR is desirable as to the sensing characteristic during read-out. More specifically, because the floating gates FG1 and FG2 and source/drain regions BL1 and BL2 are so strongly coupled, the potentials of the floating gates FG1 and FG2 are sufficiently influenced by the potentials of the source/drain regions BL1 and BL2. Consequently, the current window is widened and promotes rapid read-out.

Some different schemes are available for reducing the capacitance ratio CR. For example, the tunnel insulation layers 15a may be made thinner than the inter-polycrystalline layers 15b. Alternatively, the area over which each floating gate FG1 or FG2 faces the control gate CG may be made smaller than the area over which the floating gate faces the source/drain region BL1 or BL2 as far as possible. To reduce this area, each floating gate FG1 or FG2 may be provided with a trapezoidal shape facing the control gate CG over a small area, but facing the source/drain region BL1 or BL2 over a large area.

As for the relation between the capacitance ratio CR and deletion, when electrons should be discharged from the floating gate FG1 or FG2 to the control gate CG, the capacitance ratio should preferably be as small as possible in order to reduce the potential difference between the source/drain region BL1 or BL2 and the control gate CG. This is because a small capacitance ratio allows a potential difference to be easily established between the floating gate FG1 or FG2 and the control gate CG. Conversely, if the capacitance ratio RC is small when electrons should be withdrawn from the floating gate FG1 or FG2 to the source/drain region BL1 or BL2, then the potential difference between the source/drain region BL1 or BL2 and the control gate CG must be increased. This is because a potential difference cannot be easily established between the floating gate FG1 or FG2 and the source/drain region BL1 or BL2.

In the illustrative embodiment, a plurality of cell transistors are arranged in the direction in which the source/drain regions BL1 and BL2 are positioned side by side. An insulation layer 15f is positioned between the floating gate FG1 of one of nearby cell transistors and the floating gate FG2 of the other cell transistor for thereby electrically isolating the control gate CG and the source/drain regions BL1 and BL2. Why the insulation layer 15f is significant will be described hereinafter.

In the configuration shown in FIG. 2, the control gate CG and bit line BL2 face each other in a portion A between the cell transistors TC adjoining each other in the direction of row. Therefore, there is a fear that a leak current flows between the control gate CG and the bit line BL2 in the portion A during various kinds of operation. In light of this, it is preferable to connect the selective oxide layer or fourth insulation layer 34 to the tunnel insulation layers 15a andmake the former thicker than the latter, thereby obviating the above leak current on the basis of the thickness of the selective oxide layer 34. For this purpose, in FIG. 2, the fourth insulation layer is formed by selective oxidation.

In the S type memory, after the floating gates FG1 and FG2 have been so formed as to be separate from, but adjoin, each other by etching, an insulator is filled in the space between the floating gates FG1 and FG2 to form the insulation layer 15f. Subsequently, the control gate CG is formed above the floating gates FG1 and FG2 and insulation layer 15f. In this configuration, the floating gates FG1 and FG2 face the control gate CG only in the portions where the inter-polycrystalline insulation layers 15b are present.

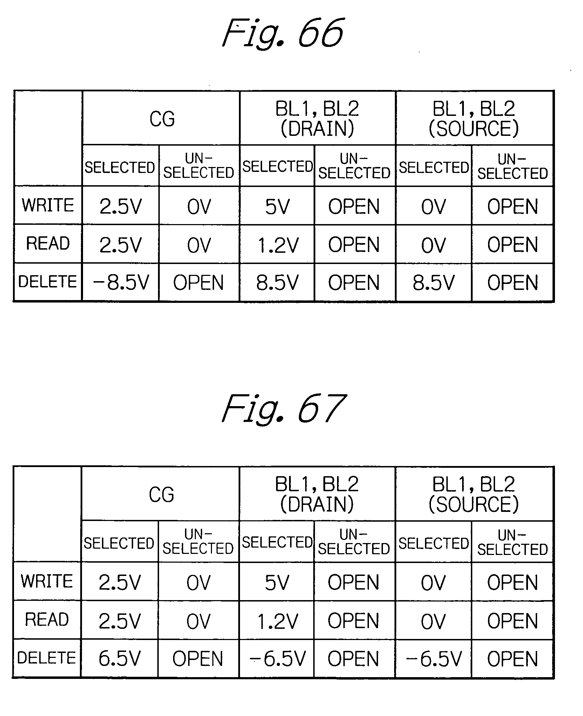

Data are written to or read out of the cell transistor of the illustrative embodiment or deleted in exactly the same manner as described with reference to FIGS. 1 and 2. In the delete mode, electrons should preferably be withdrawn from the floating gate FG1 or FG2 to the source/drain region BL1 or BL2. FIG. 66 shows specific voltages assigned to the source/drain regions BL1 and BL2 and control gate CG in the write, read and delete modes.

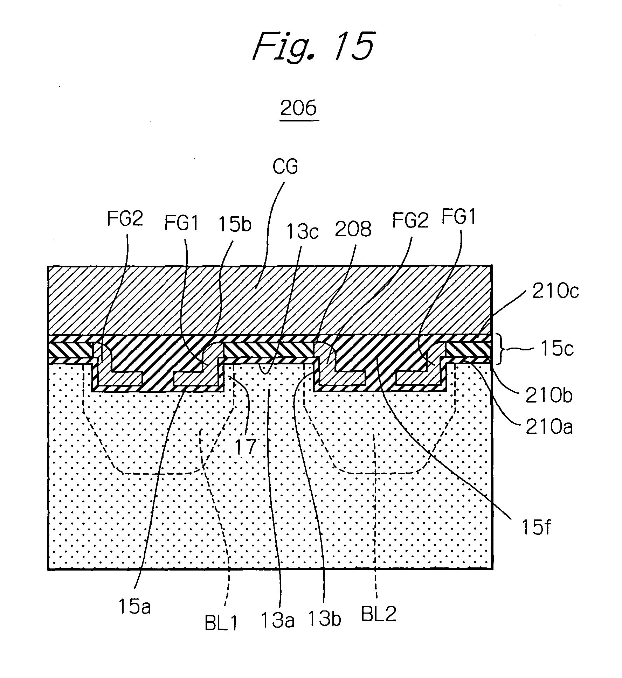

Reference will be made to FIG. 15 for describing another alternative embodiment of the present invention, which will be referred to as an L type memory for a reason to be described later. As shown, a flash memory 206 includes the P type semiconductor substrate formed with the projection 13a having opposite side walls 13b, gate insulation layer 15c formed on the top of the projection 13a, N type source/drain regions BL1 and BL2 formed on the surface of the substrate at opposite sides of the proj ection 13a, and tunnel insulation layers 15a covering the side walls 13b and source/drain regions BL1 and BL2. The floating gates FG1 and FG2 face the side walls 13b of the projection 13a and source/drain regions BL1 and BL2 via the tunnel insulation layers 15a. The inter-polycrystalline insulation layers 15b are formed on the floating gates FG1 and FG2. The control gate CG at least partly faces the floating gates FG1 and Fg2 via the inter-polycrystalline insulation layers 15b and faces the top 13c of the projection 13a via the gate insulation layer 15c.

Again, the portions of the control gate CG facing the floating gates FG1 and FG2 and the portion of the same facing the top 13c of the projection 13a may be formed electrically independently of each other and electrically controlled independently of each other.

In the illustrative embodiment, each floating gate FG1 or FG2 has a surface 208, which faces the control gate CG via the inter-polycrystalline insulation layer 15b, smaller in area than a surface facing the source/drain region BL1 or BL2 via the tunnel insulation layer 15a, as seen in a section perpendicular to the direction of column. Particularly, in the illustrative embodiment, each floating gate FG1 or FG2 is generally configured in the form of a letter L; the side and bottom of the letter L respectively face the side wall 13b of the projection 13a and the source/drain region BL1 or BL2 via the tunnel insulation layer 15a. Further, the top of the letter L faces the control gate CG via the inter-polycrystalline insulation layer 15b. This is why the semiconductor memory of the illustrative embodiment is referred to as an L type memory.

In the illustrative embodiment, the inter-polycrystalline insulation layer 15b is implemented as a silicon oxide layer formed by plasma oxidation. The gate insulation layer 15c includes, in addition to the inter-polycrystalline insulation layer 15b, a silicon oxide layer 210a and a silicon nitride layer 210b underlying the insulation layer 15b. The tunnel insulation layer 15a is also implemented as a silicon oxide layer formed by plasma oxidation.

Plasma oxidation allows a uniform silicon oxide layer to be formed without regard to the plane direction, in both of (100) and (111) planes. This is desirable when the tunnel insulation layer 15a including a horizontal surface and a vertical surface should be formed by a single step. Further, an oxide layer formed by plasma oxidation has a high Q_{BD} value representative of the resistance of an oxide layer to TDDB (Time Dependent Dielectric Breakdown) and has a low SILC (Stress Induced Leakage Current) value representative of resistance to dielectric breakdown.

In the illustrative embodiment, too, the inter-polycrystalline insulation layer 15b, i.e., the layer 210c is formed after the surfaces of the floating gates FG1 and FG2 facing the control gate CG have been flattened by CMP, achieving high breakdown voltage. Should the insulation layer 15b be formed on, e.g. , polycrystalline silicon having a rough surface and used for the floating gates FG1 and FG2 , the breakdown voltage of the insulation layer 15b might be lowered to a critical degree. The flash memory 206 of the illustrative embodiment can also be produced with a minimum of risk because the individual step is conventional.

The L-shaped floating gates FG1 and FG2 have a lower coupling ratio CR than the floating gates shown in FIGS. 1 and 2 or FIG. 14. More specifically, the cell transistor of FIGS. 1 and 2 and the S type memory of FIG. 14 have coupling ratios CR of about 0.37 and 0.32, respectively, while the illustrative embodiment achieves a coupling ratio CR of 0.20 or less and can sufficiently reduce it even to about 0.17. This is because the area of the surface 208 of each floating gate FG1 or FG2, which is generally L-shaped, facing the control gate CG is small.

A low capacitance ratio CR is desirable as to the sensing characteristic during read-out, as stated earlier. More specifically, the smaller the capacitance ratio, the wider the current window and therefor the higher the data reading speed. The illustrative embodiment allows the capacitance ratio to be reduced more easily than the embodiments shown in FIGS. 1 and 2 and FIG. 14, realizing a further increase in reading speed.

As for deletion, having such a small capacitance ratio CR, the illustrative embodiment allows electrons to be withdrawn from the floating gates FG1 and FG2 to the control gate CG only if a relatively low voltage is applied, as will be understood from the reason state earlier.

Again, after the floating gate FG1 and FG2 have been so formed as to be separate from, but adjoin, each other by etching, an insulator may be filled in the space between the floating gates FG1 and FG2 to form the insulation layer 15f. In this case, the control gate CG will also be formed above the floating gates FG1 and FG2 and insulation layer 15f. In this configuration, the floating gates FG1 and FG2 face the control gate CG only in the portions where the inter-polycrystalline insulation layers 15b are present.

The size of each insulation layer 15f may be increased to substantially remove the bottom of the L-shaped floating gate FG1 or FG2 by filling the insulator in the larger space, configuring the floating gate F1 or F2 in the form of a letter I. In such a case, although the capacities C_{FS} and C_{FD} between the floating gates FG1 and FG2 and the bit lines BL1 and BL2, respectively, decrease, the memory can be further integrated while preserving the advantages of the illustrative embodiment.

Data are written to or read out of the cell transistor or deleted in exactly the same manner as described with reference to FIGS. 1 and 2. In the delete mode, electrons should preferably be withdrawn from the floating gate FG1 or FG2 to the control gate CG. FIG. 67 shows specific voltages assigned to the source/drain regions BL1 and BL2 and control gate CG in the write, read and delete modes.

The embodiments shown in FIGS. 14 and 15 both are characterized in that the inter-polycrystalline insulation layer 15b is formed after the surfaces of the floating gates FG1 and FG2 have been flattened by the CMP in order to increase breakdown voltage, and that an insulator is filled in the space between nearby floating gates FG1 and FG2 for forming the insulation layer 15f while the control gate CG is formed on the insulation layer 15f.

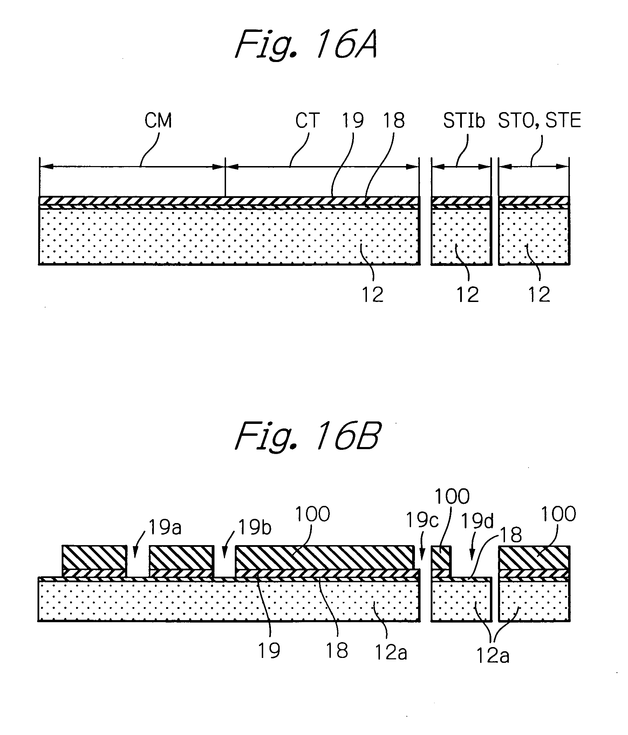

A procedure for manufacturing the semiconductor memory shown in FIGS. 1 and 2 will be described with reference to FIGS. 16A through 35. In the illustrative embodiment, the cell transistors can be produced in parallel with CMOS transistors constituting the drive transistors. For this reason, a procedure for producing CMOS transistors will be described together with a procedure for producing the cell transistors. In the figures, a CMOS transistor portion CM refers to a position where a CMOS transistor is expected to be formed while a cell transistor portion CT refers to a portion where a cell transistor is expected to be formed. How the device isolation regions STIb are formed will be described together with the above procedures.

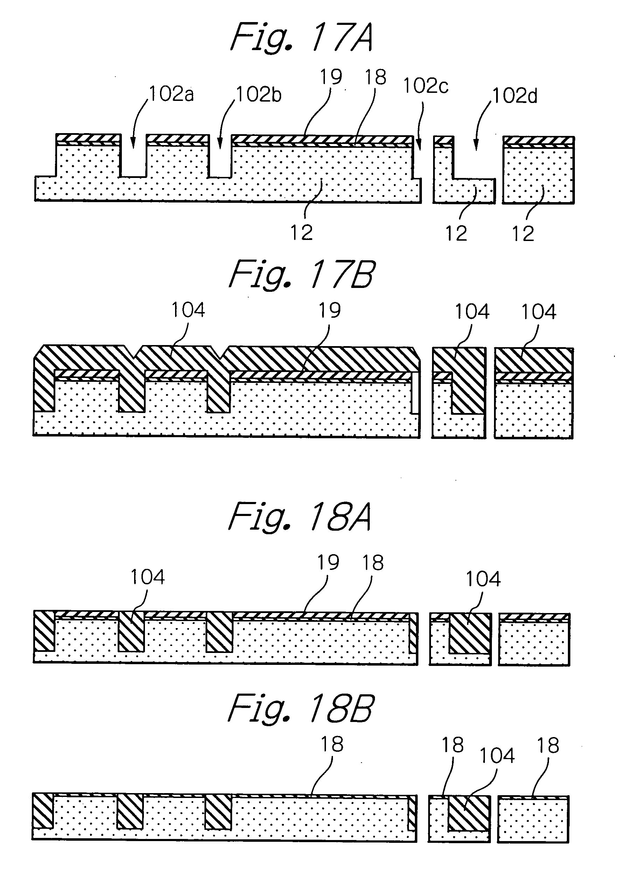

FIGS. 16A and 16B each show the following three sections. The left section is a section as seen in the direction of row, showing the cell transistor portion CT. The middle section is a section as seen in a direction AA of FIG. 13, showing the device isolation region STIb in the direction of column. The right section is a section as seen in a direction BB of FIG. 13, showing the bank select transistor STO or STE in the direction of column. FIGS. 17A through 35 also show the device isolation region STIb and bank select transistor STO or STE in sections together with the cell transistor portion CT.

First, as shown in FIG. 16A, a P⁻ type or one conductivity type silicone substrate 12 is prepared. In the illustrative embodiment, the boron concentration of the substrate 12 is 1.0 x 10¹⁶ cm⁻³. After a silicon thermal oxide layer 18 has been formed on the primary surface of the substrate 12, a silicon nitride layer 19 is formed on the oxide layer 18. Steps shown in FIGS . 16A through 18B are effected to form the device isolation regions STIa and STIb in the directions of row and column, respectively.

Subsequently, as shown in FIG. 16B, a photoresist layer 100 is coated on the silicon nitride layer 19 and then patterned by development and exposure. The silicon nitride layer 19 is patterned via the resulting photoresist pattern to form openings 19a through 19d. The opening 19a is formed in the device isolation regionbetween CMOS transistors in the CMOS transistor portion CM. The opening 19b is formed in the device isolation region between the CMOS transistor portion CM and the cell transistor portion CT. The opening 19c is formed in the device isolation region STIa extending in the direction of row in the cell transistor portion CT. Further, the opening 19d is formed in the device isolation region STIb extending in the direction of column in the cell transistor portion CT.

FIG. 17A shows a step to follow the step of FIG. 16B. As shown, after the resist pattern 100 has been removed, the silicon oxide layer 18 and silicon substrate 12 are etched with the pattern silicon nitride layer 19 serving as a mask, so that openings 102a through 102d are formed. Subsequently, as shown in FIG. 17B, silicon oxide 104 for device isolation is deposited to thickness of, e. g. , 400 nmby CVD (Chemical Vapor Deposition) , burying the openings 102a through 102d.

As shown in FIG. 18A, after the step of FIG. 17B, the silicon oxide layer 104 is polished by CMP and flattened thereby. The polishing is stopped halfway in the nitride layer 19. Thereafter, as shown in FIG. 18B, the nitride layer 19 is removed, and the oxide layer 18 is flattened.

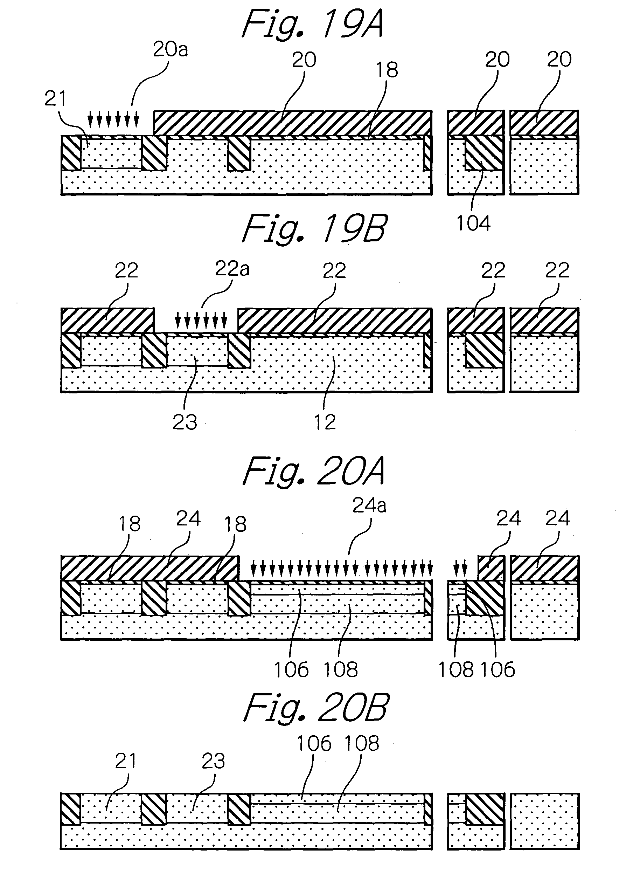

As shown in FIG. 19A, after the step of FIG. 18B, a photoresist layer 20 is coated on the entire surface of the laminate and then exposed and developed to form an opening 20a in the CMOS transistor portion CM. Subsequently, arsenic ions and phosphor ions are implanted independently of each other to form an N type well 21 beneath the opening 20a. At this instant, the arsenic ions and phosphor ions are implanted to a deep position and a shallow position, respectively.

As shown in FIG. 19B, after the formation of the N type well 21, the photoresist layer 20 is removed. Subsequently, a new photoresist layer 22 is coated on the entire surface of the laminate and then exposed and developed to form an opening 22a in the CMOS transistor portion CM. Thereafter, BF₂ (boron fluoride) ions and boron ions are implanted over the photoresist layer or mask 22 independently of each other to thereby form a P type well 23 beneath the opening 22a. At this instant, the boron ions and BF₂ ions are implanted to a deep position and a shallow position, respectively. After the formation of the P type well 23, the photoresist layer 22 is removed.

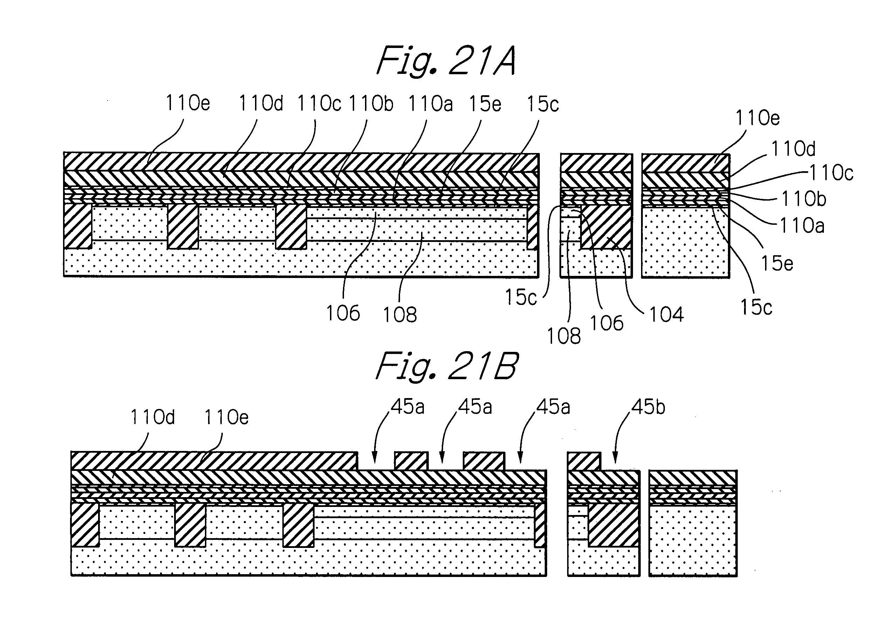

Subsequently, as shown in FIG. 20A, a photoresist layer 24 is coated on the entire surface of the laminate and then exposed and developed to form an opening 24a in the cell transistor portion CT. Thereafter, BF₂ ions and boron ions are implanted over the photoresist layer or mask 24 independently of each other, forming a P type layer 106 and a P⁺ type layer 108 at a shallow position and a deep position, respectively. Boron ions and BF₂ ions are implanted to a deep position and a shallow position, respectively. More specifically, BF₂ ions, which is a seed, are implanted with acceleration energy of 35 keV in a dose of 4.0 x 10¹¹ cm⁻² while B (boron) ions, which is also a seed, are implanted with acceleration energy of 20 keV in a dose of 2.0 x 10¹² cm⁻². The P type layer 106 forms the channel of the transistor. The P⁺ type layer serves to protect the cell transistor from punch-through.

As shown in FIG. 20B, after the photoresist layer 24 has been removed, the silicon oxide layer 18 is removed by etching.

As shown in FIG. 21A, after the step of FIG. 20B, the surface of the substrate 12 is again thermally oxidized to form a gate insulation layer 15c, which is about 3 nm thick. Subsequently, an about 20 nm thick, gate insulation layer 15e, which is a silicon nitride layer, an about 20 nm thick, silicon oxide layer 110a, an about 20 nm thick, silicon nitride layer 110b, an about 4 nm thick silicon oxide layer 110c, an about 100 nm thick, silicon nitride layer 110d and an about 50 nm silicon oxide layer 110e are sequentially stacked on the gate insulation layer 15c in this order. The functions of these layers will become apparent from the description of steps to follow. Such layers all are formed by CVD.

As shown in FIG. 21B, after the step of FIG. 21A, a photoresist layer, not shown, is coated on the silicon oxide layer 110e on the top of the laminate and then exposed and developed to form stripe-like openings not shown. Subsequently, the silicon oxide layer 110e is etched via the above openings to thereby form stripe-like openings 45a and 45b. The openings 45a are formed at positions where the source/drain regions of the cell transistor will be formed. The opening 45b is formed at a position where the device isolation region STIb and bank select transistor STO or STE will be formed.

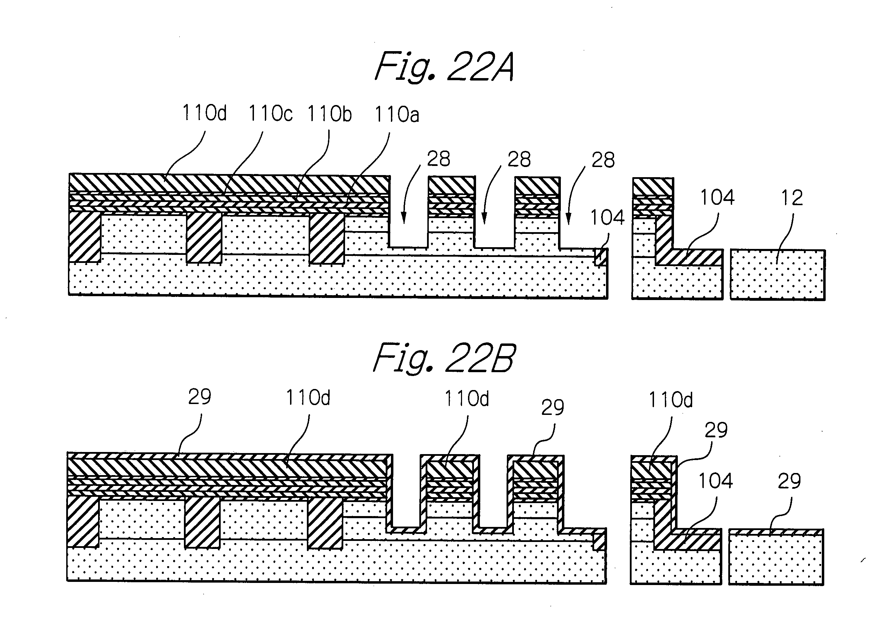

As shown in FIG. 22A, after the photoresist layer used in the step of FIG. 21B has been removed, the silicon nitride layer 110d is removed by RIE (Reactive Ion Etching) , which is anisotropic etching, via the openings 45a and 45b. This is followed by the steps of etching the silicon oxide layers 110e and 110c, removing the silicon nitride layer 110b by RIE, and then etching the silicon oxide layer 110a. Further, after the silicon nitride layer 15e has been removed by RIE, trenches 28 are formed in the P and P⁺ type layers 106 and 108, which are silicon layers. While the size of each trench 28 is open to choice, it is about 40 nm deep in the illustrative embodiment. Also, the distance between nearby trenches 28, i.e., the width of each projection 13a is about 130 nm.

As shown in FIG. 22B, after the step of FIG. 22A, an about 20 nm thick, silicon oxide layer 29 is formed on the entire exposed surface of the laminate by CVD.

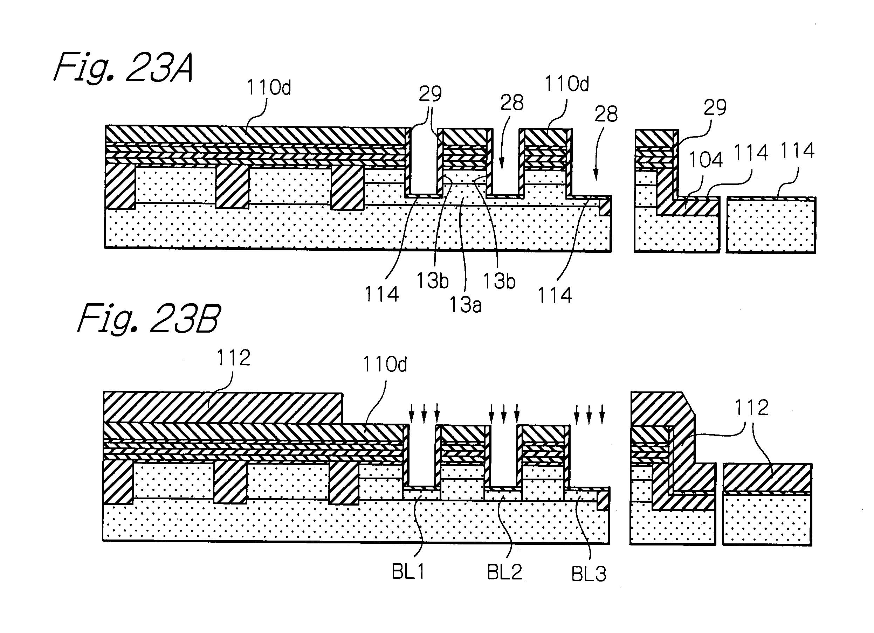

As shown in FIG. 23A, the silicon oxide layer 29 is removed by RIE in the direction of thickness with the result that the silicon oxide layer 29 is removed except for its portions covering the side walls 13b of the projections 13a. This is followed by thermal oxidation for forming 3 nm thick, silicon oxide layers 114 on the bottoms of the trenches 28.

Subsequently, as shown in FIG. 23B, a photoresist layer 112 is coated on the laminate and then exposed and developed. As a result, the photoresist layer 112 is removed except for its portions present in the CMOS transistor portion and STI portion positioned at the right-hand side. Thereafter, arsenic ions are implanted two times over the photoresist layer or mask 112 to thereby form N⁺ type layers, which constitute the bit lines BL1, BL2 and so forth, on the bottoms of the trenches 28. More specifically, arsenic ions are implanted with acceleration energy of 10 keV in a dose of 1.5 x 10¹⁴ cm⁻² and then implanted with acceleration energy of 30 keV in a dose of 1.0 x 10¹⁴ cm⁻². At this instant, the silicon oxide layers 29 left on the side walls 13b of the projection 13a prevent arsenic ions frombeing implanted in the side walls 13b. Further, the projections 13a, serving as a mask, allow the bit lines BL1, BL2 and so forth to be formed on the bottoms of the trenches 28 by self-alignment.

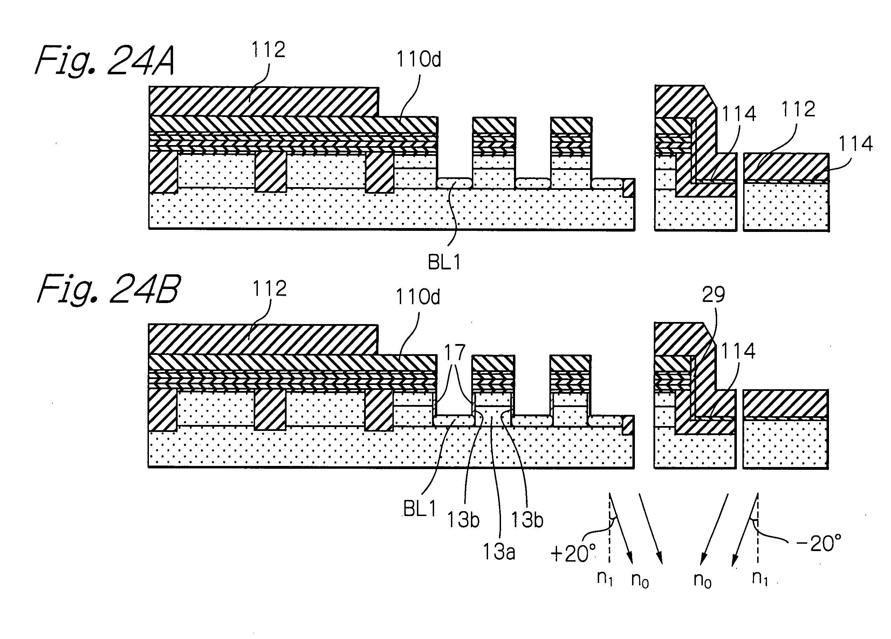

As shown in FIG. 24A, after the step of FIG. 23B, the silicon oxide layers 29 on the side walls 13b of the proj ections 13a and silicon oxide layers 114 on the bottoms are removed by etching. Subsequently, as shown in FIG. 24B, arsenic ions are implanted in the side walls 13b to thereby formN type regions 17 of counter conductivity type. To implant arsenic ions in the side walls 13b, the substrate 12 should only be inclined relative to the direction of ion implantation. In the illustrative embodiment, the line n₁ normal to the P type silicon substrate 12 is inclined by about ±20° relative to the direction of ion implantation no. More specifically, arsenic ions are implanted with acceleration energy of 15 keV in a dose of 2.0 x 10¹² cm⁻² .

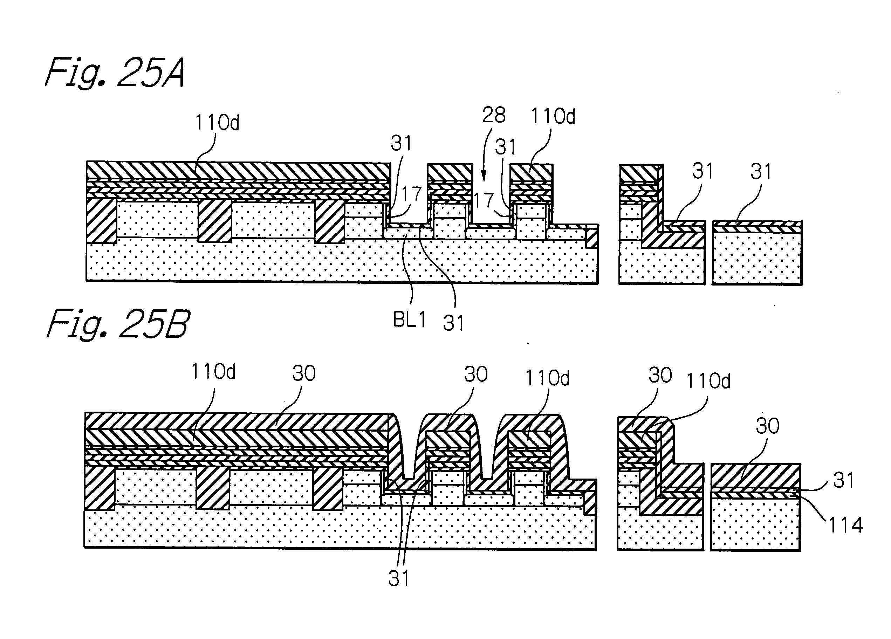

Again, the surface layers of the trenches 28 are expected to implement the channel of the device, so that the property of the surface layers has critical influence on the device characteristics. It is therefore necessary to protect the surfaces of the trenches 28 from contamination in the steps to follow. For this purpose, as shown in FIG. 25A, the illustrative embodiment forms an about 4 nm thick, sacrifice silicon oxide layer 31 on the sides and bottoms of the trenches 28 by thermal oxidation. The sacrifice silicon oxide layer 31 successfully protects the surfaces of the trenches 28 from contamination. Moreover, this layer 31 serves to remove a lattice defect particular to the surface layers of the trenches 28, thereby preventing the device characteristics from being degraded.

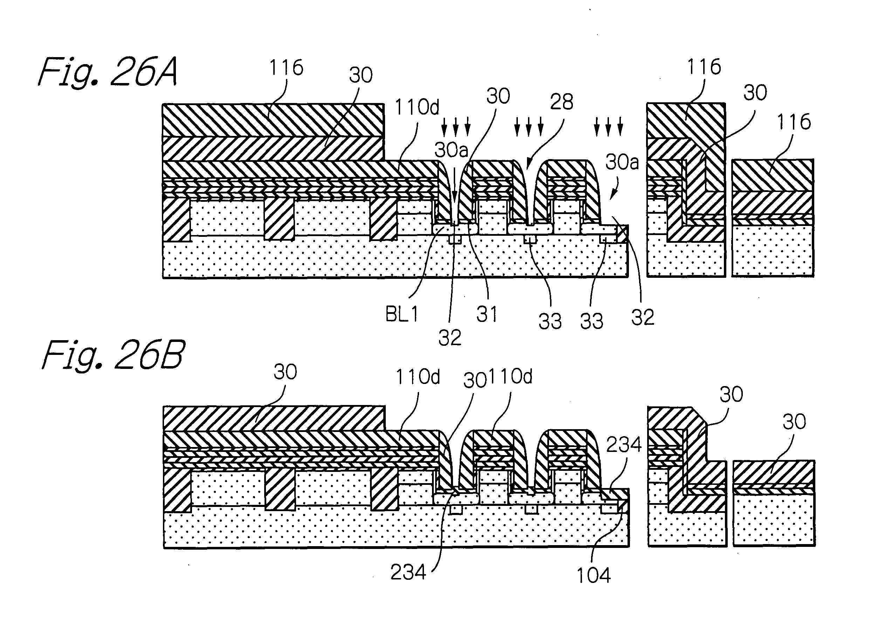

Subsequently, as shown in FIG. 25B, an about 60 nm thick, silicon nitride layer 30 is formed on the entire exposed surface of the laminate inclusive of the inside of the trenches 28 by CVD. Thereafter, as shown in FIG. 26A, a photoresist layer 116 is coated and then has its portions corresponding to the source/drain regions of the cell transistor portion CT removed. This is followed by a step of anisotropically etching the silicon nitride layer 30 in the direction of thickness over the photoresist layer or mask 116 to thereby form elongate openings 30a extending in the direction of column. It should be noted that the elongate openings 30a are smaller in width than the trenches 28. After the formation of the openings 30a, the sacrifice silicon oxide layer 31 and part of the bit lines BL1, BL2 and so forth are selectively etched via the silicon nitride layer 30 to form recesses 32 in the bit lines BL1, BL2 and so forth. The recesses 32 are about 10 nm deep each.

After the above selective etching, arsenic ions are implanted in the bit lines BL1, BL2 and so forth via the elongate openings 30a in order to lower the resistance of the bit lines. In FIG. 26A, the portions where arsenic ions are implanted, i.e., N⁺ type regions are labeled 33. More specifically, As, which is a seed, is implanted with acceleration energy of 40 keV in a dose of 5.0 x 10¹⁵ cm⁻².

As shown in FIG. 26B, after the As implantation, the photoresist layer 116 is removed. Subsequently, the recesses 32 are subject to selective thermal oxidation via the silicon nitride layer 30 serving as a mask to thereby form selective oxide layers 234. Why the oxide layers 234 are swelled and thickened by such oxidation is that the breakdown voltage of the oxide layers 234 should be increased because the control gate CG and source/drain regions BL are closest to each other there.

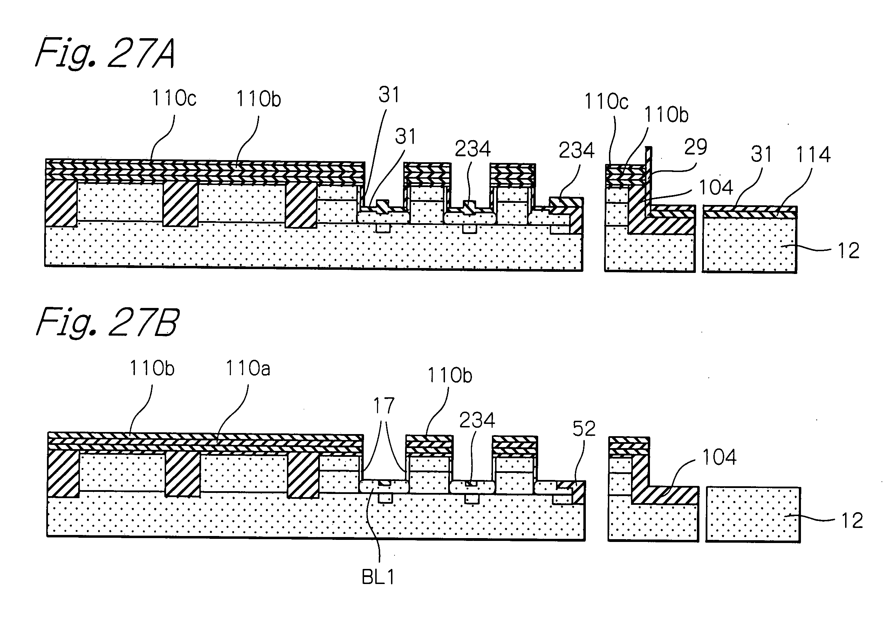

As shown in FIG. 27A, after the step of FIG. 26B, the silicon nitride layers 30 and 110d are removed by etching. At this instant, the silicon oxide layer 110c and sacrifice silicon oxide layer 31 play the role of an etching stopper. Subsequently, as shown in FIG. 27B, the silicon oxide layer 110c and sacrifice silicon oxide layer 31 are removed by etching. At this time, the silicon nitride layer 110b plays the role of an etching stopper. This etching is effected to such a degree that the silicon oxide layer 110c and sacrifice silicon oxide layer 31 are fully removed, but the selective oxide layers 234 remain.

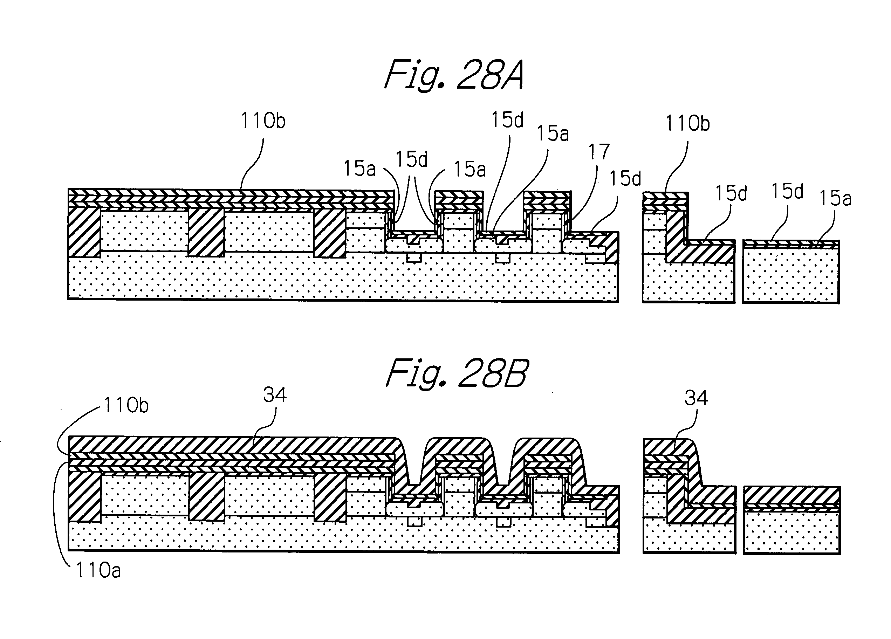

As shown in FIG. 28A, after the step of FIG. 27B, about 3 nm thick, tunnel insulation layers or plasma oxide layers 15a and about 3 nm thick, tunnel insulation layers or plasma nitride layers 15d are formed on the bottoms and sides of the trenches 28. The tunnel insulation layers should preferably be provided with desirable property because they have critical influence on the device operation. This is why the two plasma oxide layers 15a and 15d are stacked. To form the plasma oxide layers 15a, use may be made of the microwave excited, high density plasma device using a radial line slot antenna.

In the plasma device mentioned above, a Kr and O₂ mixture gas is introduced into the device. Krypton is excited by a microwave issuing from the radial line slot antenna and hits against O₂ for thereby generating a great amount of atomic state oxygen O^{*}. The atomic state oxygen O^{*} easily enters the surface layers of the trenches 28 and oxidizes the bottoms and sides of the trenches 28 at substantially the same rate without regard to the plane direction. After the oxide layers have been formed, the feed of the mixture gas and the emission of the microwave are stopped, and then the device is exhausted.

Subsequently, the plasma nitride layers 15d are formed on the plasma oxide layers 15a by use of, e.g. , the microwave excited, high density plasma device using a radial line slot antenna. In this case, a Kr and ammonia (NH₃) mixture gas is introduced into the device. Kr is excited by a microwave issuing from the radial line slot antenna and hits against NH₃ for thereby generating ammonia radials NH* . The ammonia radicals NH^{*} form plasma nitride layers on the surfaces of the trenches 28 without regard to the plane direction of silicon.

As shown in FIG. 28B, after the formation of the tunnel insulation layers 15d, a polycrystalline silicon layer or conductive layer 34 is formed on the tunnel insulation layers 15d and silicon nitride layers 110b. The polycrystalline silicon layer 34 is doped with phosphor (P) beforehand by an in-situ process. Why the polycrystalline silicon layer 34 is doped with P is that it is expected to constitute the floating gates FG1 and FG2 and should preferably be lowered in resistance. The polycrystalline silicon layer 34 is about 60 nm thick.

Subsequently, the polycrystalline silicon layer 34 is anisotropically etched in the direction of thickness such that it disappears on the silicon nitride layers 110b, but remains on the tunnel insulation layers 15d on the sides of the trenches 28. The tops of the polycrystalline silicon layers 34 on the sides of the trenches 28 are positioned at a higher level than the tops of the projections 13a. The polycrystalline silicon layers 34 left on the sides of the trenches 28 constitute the floating gates FG1 and FG2.

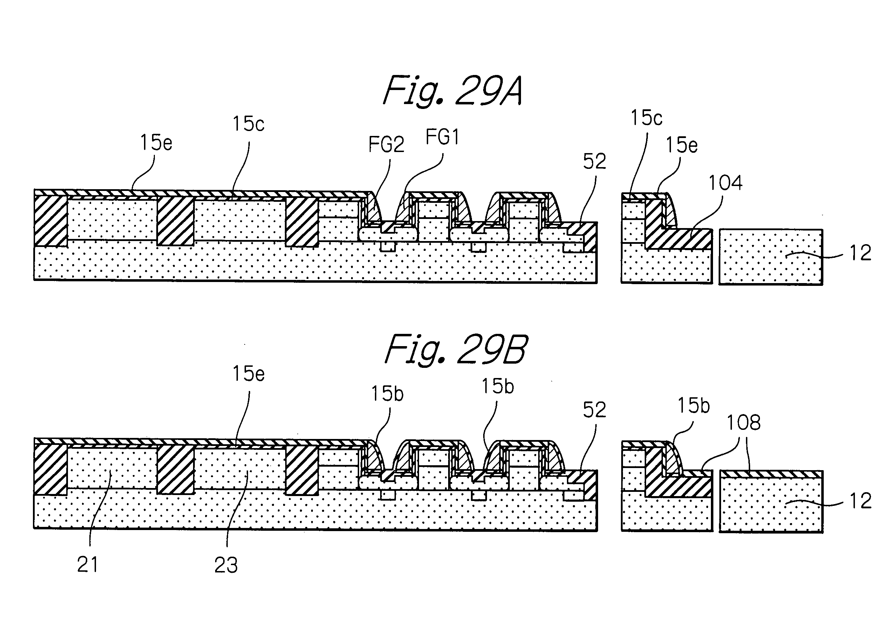

As shown in FIG. 29A, after the floating gates FG1 and FG2 have been formed, the silicon nitride layers 110b and silicon oxide layers 110a are removed by etching. Attention should be paid to the role that the silicon nitride layers 110b and silicon oxide layers 110a, FIG. 28B, have played up to this stage of production. The silicon nitride layers 110b and silicon oxide layers 110a have been formed on the gate insulation layer 15e in the step of FIG. 21A and have protected the gate insulation layers 15e up to the step of FIG. 28B.

The gate insulation layer 15e has critical influence on the device operation. In this respect, the silicon nitride layers 110b and silicon oxide layers 110a protect the gate insulation layer 15e from being deteriorated during various processes including ion implantation, etching, and stacking of different kinds of layers.

Subsequently, as shown in FIG. 29B, the entire exposed surface of the laminate is oxidized by plasma oxidation stated earlier. As a result, the surfaces of the floating gates FG1 and FG2 are oxidized to become inter-polycrystalline insulation layers 15b. At this instant, a small amount of nitrogen is mixed with the oxide layers for thereby forming nitride layers as well. These nitride layers make the inter-polycrystalline insulation layers 15b thicker and thereby prevent boron from leaking. Further, an oxide layer 108 is formed on the device isolation region STIb extending in the direction of column and the bank select transistor STO or STE. The inter-polycrystalline insulation layers 15b are about 12 nm thick each.

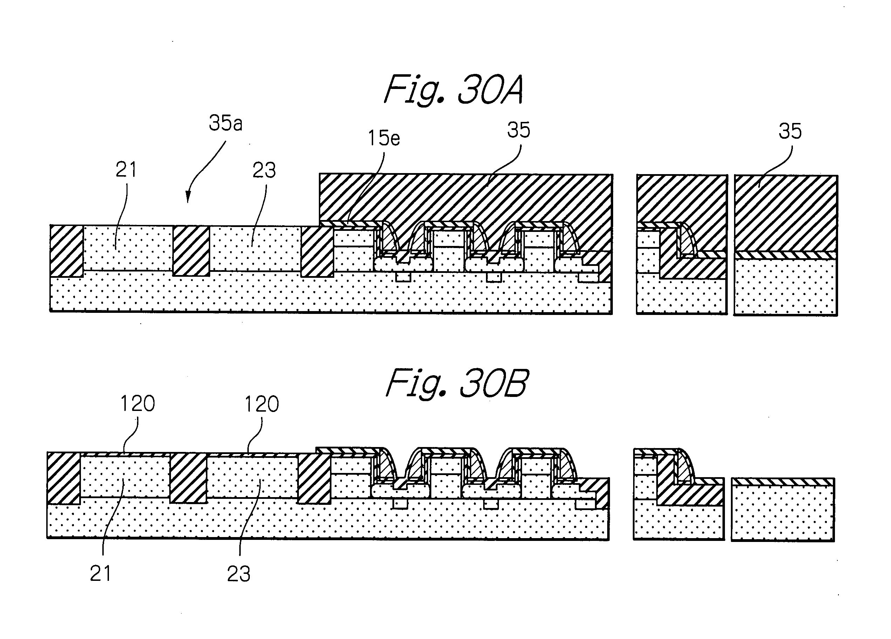

As shown in FIG. 30A, after the step of FIG. 29B, a photoresist layer 35 is coated on the entire surface of the laminate and then exposed and developed to thereby form an opening 35a on the CMOS transistor portion CM. Subsequently, the gate insulation layers 15e and 15c on the CMOS transistor portion CM are etched over the photoresist layer or mask 35, so that the surfaces of the N type well 21 and P type well 23 of the CMOS transistor are exposed to the outside. Why the gate insulation layers 15e and 15c are so etched is that the gate insulation layers 15c have been disfigured by the preceding steps.

As shown in FIG. 30B, after the photoresist layer 35 has been removed, about 3 nm thick, gate oxide layers 120 are formed on the surfaces of the N type well 21 and P type well 23 of the CMOS transistor by plasma oxidation. At this instant, plasma oxidation additionally serves to transform carbon (C) present in the photoresist layer 35, which may be left on the surface of the inter-polycrystalline layer 15b, to CO₂ for thereby removing the photoresist layer 35.

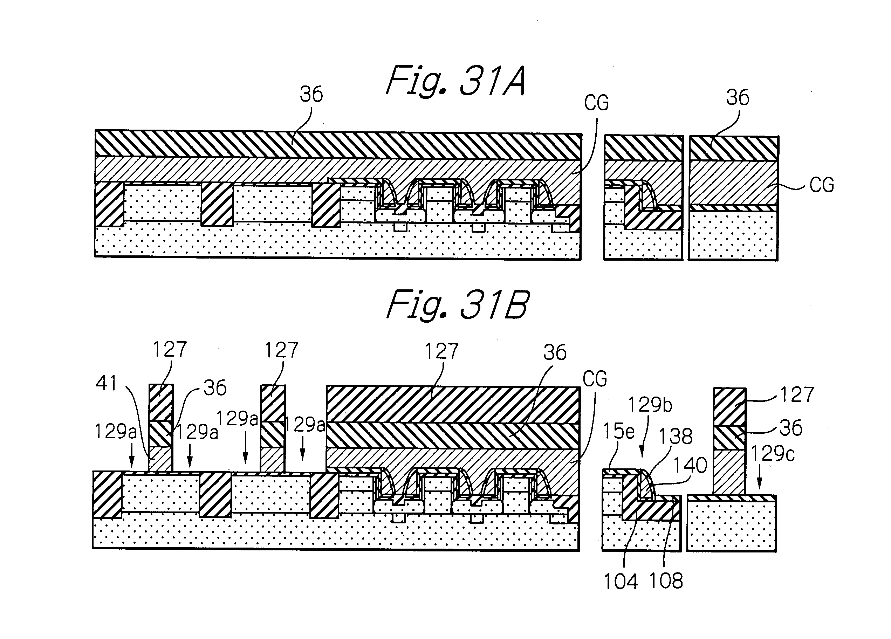

As shown in FIG. 31A, after the step of FIG. 30B, a polycrystalline silicon layer CG is formed by CVD and then has its surface polished by CMP and flattened thereby. After a WSi (tungsten silicide) layer has been formed, a silicon oxide layer 36 is formed on the WSi layer. In FIG. 31A, the polycrystalline silicon layer and CG and WSi layers overlying it are collectively labeled CG. By the step of FIG. 31A, a plurality of control gates CG, each extending in the direction of row, are formed. At the same time, gate electrodes 41 are formed on the P type well 23 and N type well 21 of the CMOS transistor portion. The gate electrodes 41 are mainly constituted by the polycrystalline silicone layer and lowered in resistance by the WSi layer. The WSi layer is formed on the control gate CG also and therefore lowers the resistance of the control gate CG as well.

The silicon oxide layer 36 is formed on the polycrystalline silicon layer CG, as stated above, in order to pattern the polycrystalline silicon layer CG by using the silicon oxide layer 36 as a mask. This is more preferable than patterning the polycrystalline silicon layer CG by using a photoresist layer as a mask. The polycrystalline silicon layer CG is patterned by the following procedure.

As shown in FIG. 31B, after a photoresist layer 127 has been coated and then exposed and developed in a preselected pattern, the silicon oxide layer 36 is patterned with the patterned photoresist layer 127 serving as a mask. Subsequently, the polycrystalline silicon layer CG is patterned with the patterned silicon oxide layer 36 serving as a mask. As shown in the figure, the polycrystalline silicon layer CG, i.e. , the control gate CG is removed in portions 129a assigned to the source/drain regions of the CMOS transistor portion CM, a portion 129b assigned to the device isolation region STIb of the cell transistor portion CT, which extends in the direction of column, a portion 129c assigned to the source/drain region of the bank select transistor STO or STE, and the region, FIG. 1, between the control gates CG each extending in the direction of row.

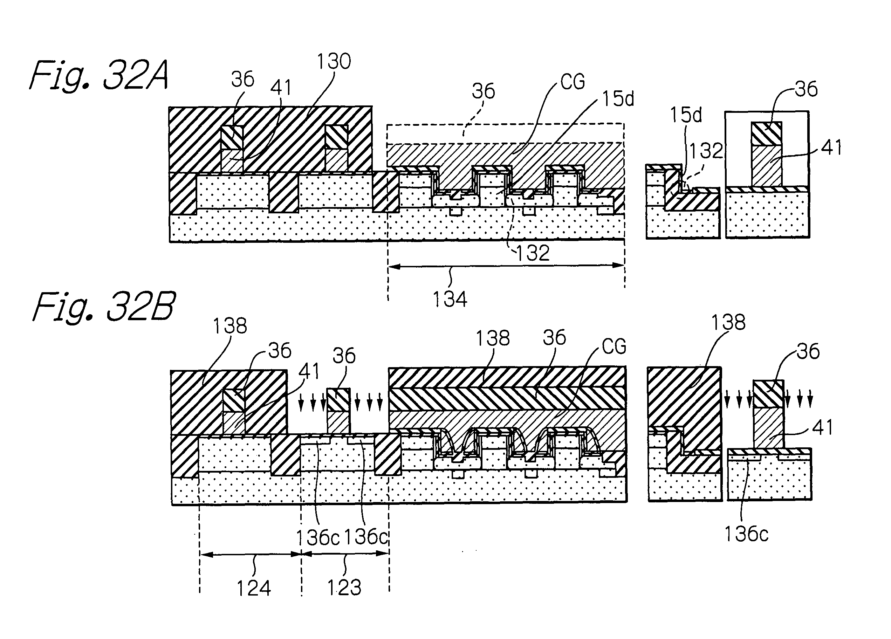

Subsequently, the inter-polycrystalline insulation layers 138 and polycrystalline silicon layers 140 left on the portions not covered with the control gates CG, i.e. , the sides of the projections 13a present in the device isolation regions STIb and the sides of the projections 13a present in the device isolation region 40, FIG. 1, are removed. More specifically, as shown in FIG. 32A, after the photoresist layer 127 has been removed, a mask 130 is formed and then used to remove the inter-polycrystalline insulation layers 138 and polycrystalline silicon layers 140. A particular etchant is used for each of the inter-polycrystalline silicon layer 138 and polycrystalline silicon layer 140. In this manner, the floating gates FG1 and FG2 are removed from the portions not covered with the control gates CG. As a result, the tunnel insulation layer 15d is exposed to the outside between nearby control gates CG. After the removal of the polycrystalline silicone layer 140, the corners 132 of the silicon nitride layers 15d thus exposed are rounded by oxidation, i.e., an oxide is formed on the corners 132.

As for a region 134, only FIG. 32A shows the device isolation region 40 in a section in the direction of row, i.e., along line CC of FIG. 13 while FIGS. 16 through 35 show the region assigned to the source/drain regions of the cell transistor portion CT in sections in the direction of row, i.e., along line DD of FIG. 13.

FIG. 32B shows a step to follow the step of FIG. 32A and effected to form an N type MOS 123 and a P type MOS 124 of the CMOS transistor portion CM and bank select transistor STO or STE at the same time. More specifically, as shown in FIG. 32B, after the photoresist layer 130 has been removed, a photoresist layer 138 is coated and then exposed and developed such that the portions of the layer 138 corresponding to the N type MOS 123 and bank select transistor STO or STE are opened. Subsequently, arsenic ions are implanted via the resulting openings of the photoresist layer 138 to thereby form LDDs (Lightly Doped Drains) 136c . At this instant, the silicon oxide layers 36 also serve as a mask.

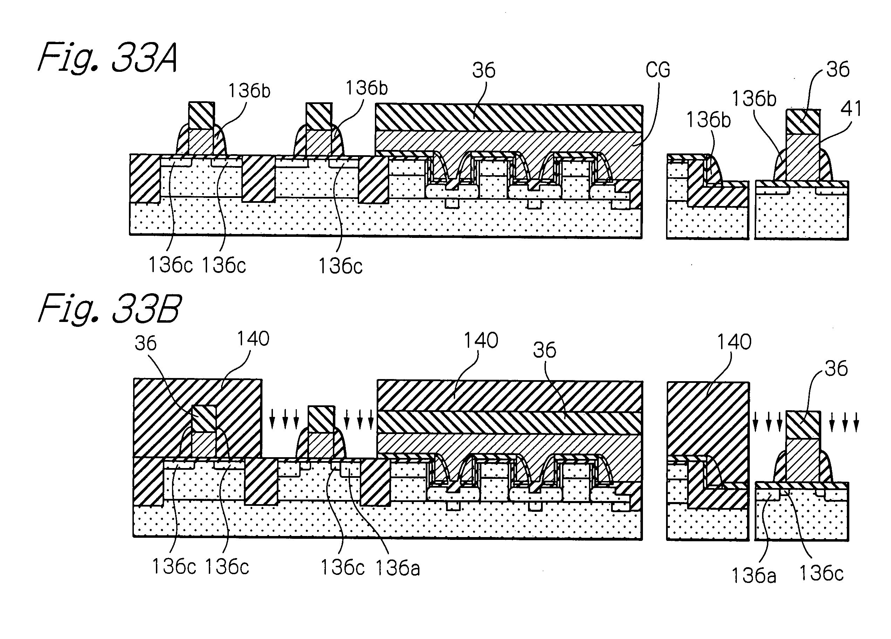

Subsequently, as shown in FIG. 33A, LDDs 136c are formed in the P type MOS 124 in the samemanner as in FIG. 32B. Thereafter, the side wall insulation layers 136b, which are implemented as silicon nitride layers, are formed on the P type MOS 124, N type MOS 123, bank select transistor STO or STE, and the projections 13a present in device isolation region STIb.

As shown in FIG. 33B, after the step of FIG. 33A, a photoresist layer 140 is coated on the laminate and then exposed and developed such that the portions of the layer 140 corresponding to the N type MOS 123 and bank select transistor STO or STE are open. Subsequently, arsenic ions are implanted via the resulting openings of the photoresist layer 140 to thereby form the source/drain regions 136a. The silicon oxide layer 36 plays the role of a mask during this step as well. Likewise, the source/drain regions 136a are formed in the P type MOS 124. In this manner, the N type MOS 123 and P type MOS 124 of the CMOS transistor portion CM and bank select transistor STO or STE are formed.

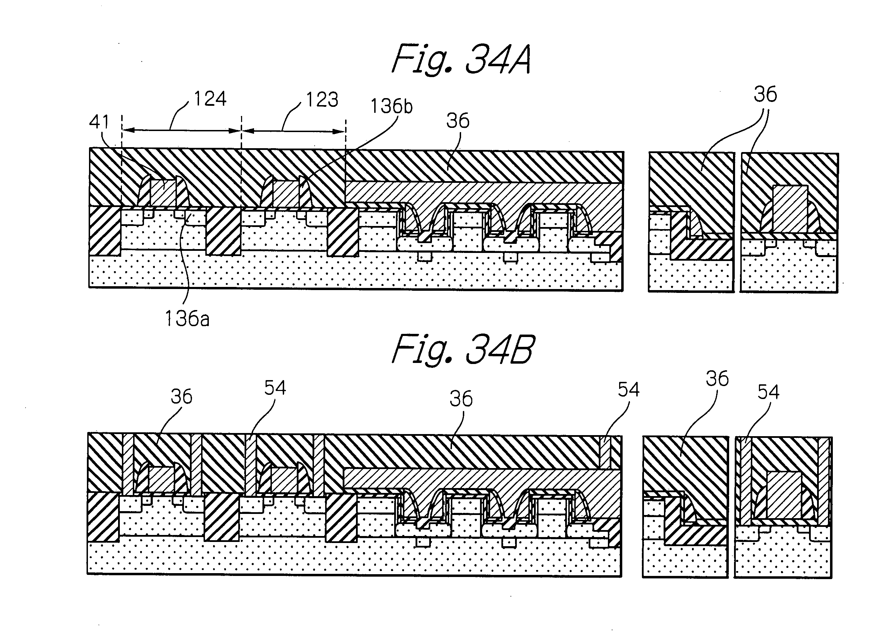

As shown in FIG. 34A, after the step of FIG. 33B, a BPSG (Boro-Phospho Silicate Glass) layer 36 is formed on the entire surface of the laminate and used to flatten the surface for aluminum wires. More specifically, after the BPSG layer 36 has been heated at high temperature to reduce the irregularity of the surface, the surface of the BPSG layer 36 is flattened by CMP.

Subsequently, as shown in FIG. 34B, holes are formed in the BPSG or silicon oxide layer 36 by use of a mask not shown. After tungsten plugs or contacts 54 have been buried in the holes, the surface of the laminate is flattened by CMP. The tungsten plugs 54 connect the control gate CG and Al layer 38 in the cell transistor portion CT and connect the source/drain regions and A1 layers 38 in the CMOS transistor portion CM and bank select transistor STO or STE.

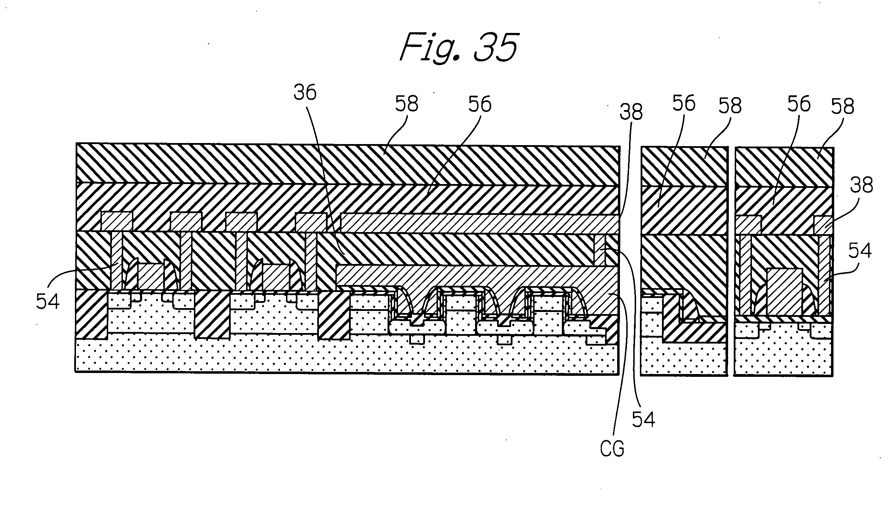

More specifically, as shown in FIG. 35, after the A1 layers 38 have been deposited by evaporation and then patterned, a silicon oxide layer 56 and a protection layer 58 are sequentially formed in this order. This is the end of the procedure for manufacturing the semiconductor memory shown in FIG. 1.

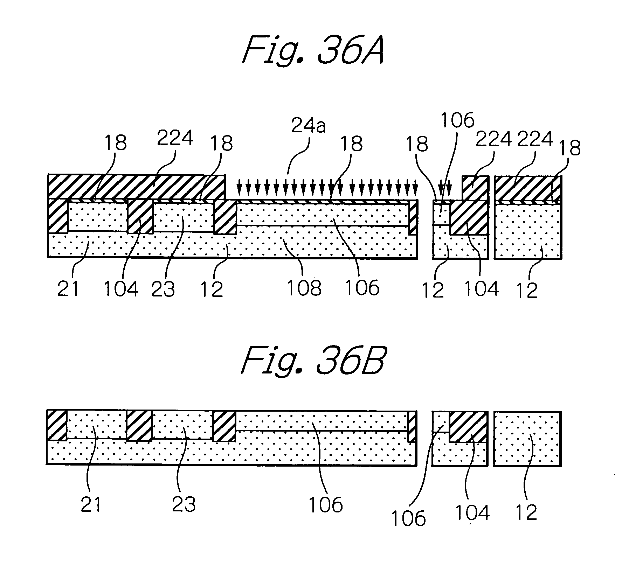

Specific processes for manufacturing the S type semiconductor shown in FIG. 14 will be described with reference to FIGS. 36A through 49. Again, the production of the cell transistors can be executed in parallel with the production of CMOS transistors, so that a procedure for producing CMOS transistors will be described hereinafter together with the procedure for producing the cell transistors. In the figures, a CMOS transistor portion CM refers to a portion allocated to a CMOS transistor to be formed later while a cell transistor portion CT refers to a portion allocated to the cell transistor. The figures demonstrate the steps of poducing the device isolation region ST1b and bank select transistor STO or STE as well.

FIGS. 36Aand 36B each show the following three sections. The left section is a section as seen in the direction of row. The middle section is a section as seen in a direction AA of FIG. 13, showing the device isolation region STIb in the direction of column. The right section is a section as seen in a direction BB of FIG. 13, showing the bank select transistor STO or STE in the direction of column. FIGS. 36A through 48 also show the device isolation region STIb and bank select transistor STO or STE in sections as seen in the direction of column.

The initial stage of production is identical with the stage previously described with reference to FIGS. 16A through 19B, so that only a step to follow the step of FIG. 19B and successive steps will be described in order to avoid redundancy. As shown in FIG. 36A, a photoresist layer 224 is coated on the entire surface of the laminate and then exposed and developed to form an aperture 24a in the cell transistor portion CT. BF₂ ions and boron ions are implanted over the photoresist layer or mask 224 independently of each other to thereby form a P⁻ type layer 106 and a P⁺ type layer 108 beneath the opening 22a at a shallow position and a deep position, respectively. At this instant, boron ions are implanted to a deep position three times while BF₂ ions are implanted to a shallow position two times. More specifically, boron ions are first implanted with acceleration energy of 30 keV in a dose of 1.0 x 10¹¹ cm⁻², then implanted with acceleration energy of 35 keV in a dose of 2.0 x 10¹² cm⁻², and then implanted with acceleration energy of 55 keV in a dose of 4.0 x 10¹² cm⁻². BF₂ ions are first implanted with acceleration energy of 15 keV in a dose of 1.0 x 10¹¹ cm⁻² and then implanted with acceleration energy of 45 keV in a dose of 1.0 x 10¹¹ cm⁻² .

By the above ion implantation, the P⁻ type layer 106 is formed with an impurity concentration of about 1.0 x 10¹⁷. cm⁻³ at a position shallower than 60 nm while the P⁺ type layer 108 is formed with an impurity concentration of about 1.0 x 10¹⁸ cm⁻³ at a position deeper than 60 nm. The P⁻ type layer 106 forms the channel of the transistor. The P⁺ type layer 108 serves to protect the cell transistor from punch-through.

Subsequently, as shown in FIG. 36B, the photoresist layer 224 is removed, and then the silicon oxide layer 18 is removed by etching using d-HF.

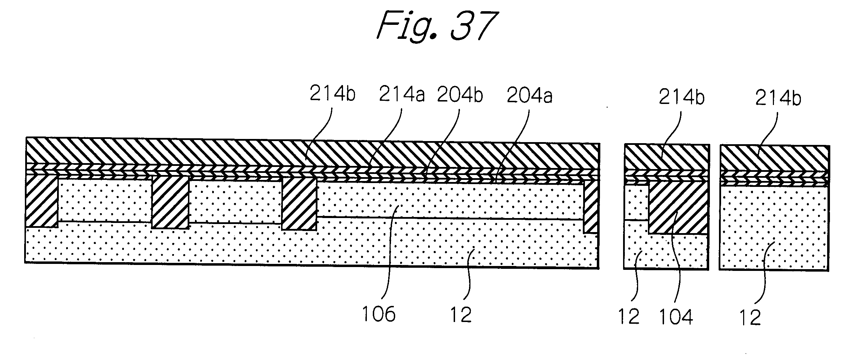

As shown in FIG. 37, after the step shown in FIG. 36B, an about 10 nm thick, gate insulation layer 204a, which is a silicon oxide layer, an about 20 nm thick, gate insulation layer 204b, which is a silicon nitride layer, an about 10 nm thick, silicon oxide layer 214a and an about 100 nm thick, silicon nitride layer 214b are sequentially stacked on the substrate 12 in this order. Such layers all are formed by CVD. The gate insulation layers 204a and 204b form part of the S type memory. The silicon oxide layer 214a serves as a sacrifice oxide layer while the silicon nitride layer 214b serves as a stopper when arsenic ions are implanted later.

As shown in FIG. 38A, after the step of FIG. 37, a photoresist, not shown, is coated on the silicon nitride layer 214b on the top of the laminate and then exposed and developed to form stripe-like openings not shown. Subsequently, the silicon nitride layer 214b, silicon oxide layer 214a, gate insulation layers 204b and 204a and silicon substrate 12 are etched by RIE via the above openings, which constitute a mask, by use of Cl₂/HF₃ gas. Subsequently, trenches 28 are formed in the P⁻ and P⁺ type layers 106 and 108, which are silicon layers, by RIE. The trenches 28 correspond in position to the drain regions BL1 through BL3 of the cell transistor TC, device isolations region STIb, and bank select transistor STO or STE. While the size of each trench 28 in the source/drain region BL1, BL2 or BL3 is open to choice, it is about 60 nm deep in the illustrative embodiment. Also, the distance between nearby trenches 28, i.e., the width of each projection 13a is about 180 nm. Each trench 28 is about 270 nm wide.

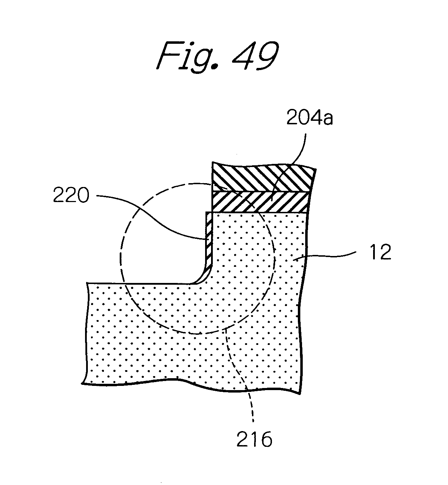

The CL₂/HF₃ gas used for RIE, as stated above, forms fluorocarbon layers 220 on the side walls of the trenches 28. More specifically, as shown in FIG. 49 in a fragmentary view, a fluorocarbon layer 220 is formed on the side wall 216 of each trench 28 in such a manner as to round the bottom corner of the trench 28. The significance of the fluorocarbon layers 220 will be described later specifically.

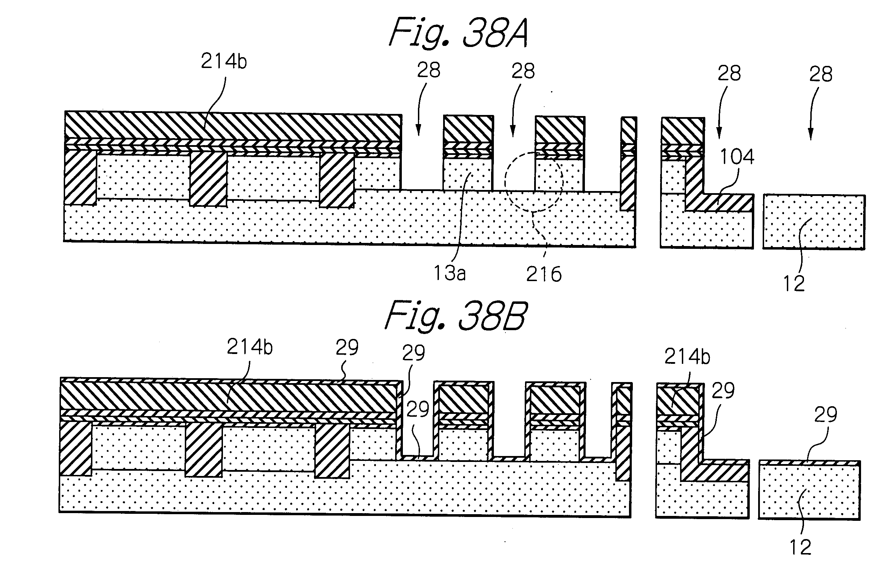

As shown in FIG. 38B, after the step of FIG. 38A, an about 15 nm thick, silicon oxide layer 29 is formed on the entire exposed surface of the laminate by CVD.

As shown in FIG. 39A, the silicon oxide layer 29 is etched by RIE in the direction of thickness with the result that the silicon oxide layer 29 is removed except for its portions covering the side walls 13b of the projections 13a.

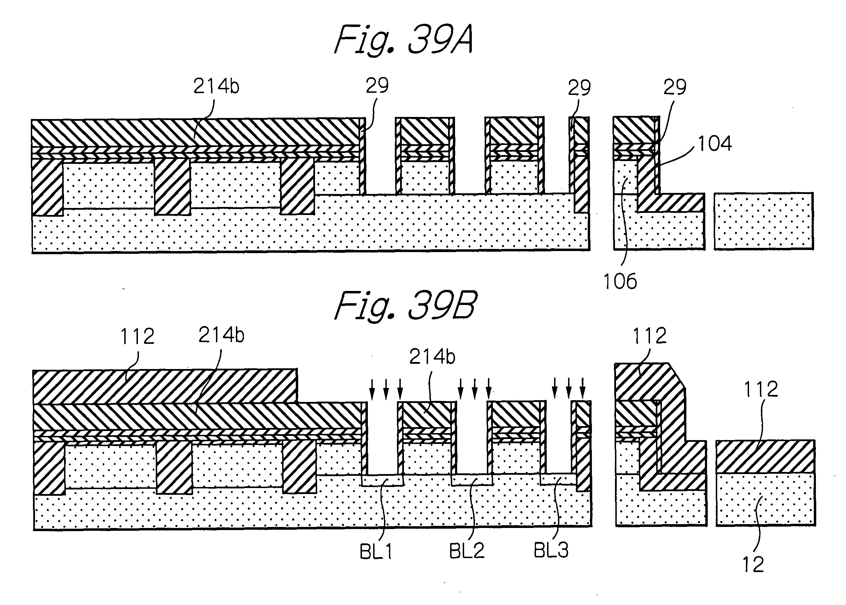

Subsequently, as shown in FIG. 39B, a photoresist layer 112 is coated on the laminate and then exposed and developed over a mask to thereby remove the photoresist layer 112 except for its portions present in the CMOS transistor portion CM, device isolation region STIb, and bank select transistor STO or STE. Thereafter, arsenic ions are implanted two times over the photoresist layer or mask 112 to thereby form N⁺ type layers, which constitute the bit lines BL1, BL2 and so forth, on the bottoms of the trenches 28. The bit lines BL1 and BL2 each have a sheet resistance of about 100 Ù/ . More specifically, arsenic ions are implanted with acceleration energy of 15 keV in a dose of 3.0 x 10¹⁵ cm⁻² and then implanted with acceleration energy of 40 keV in a dose of 3.0 x 10¹⁵ cm⁻². At this instant, the silicon oxide layers 29 left on the side walls 13b of the projection 13a prevent arsenic ions from being implanted in the side walls 13b. Further, the projections 13a, serving as a mask, allow the bit lines BL1, BL2 and so forth to be formed on the bottoms of the trenches 28 by self-alignment.

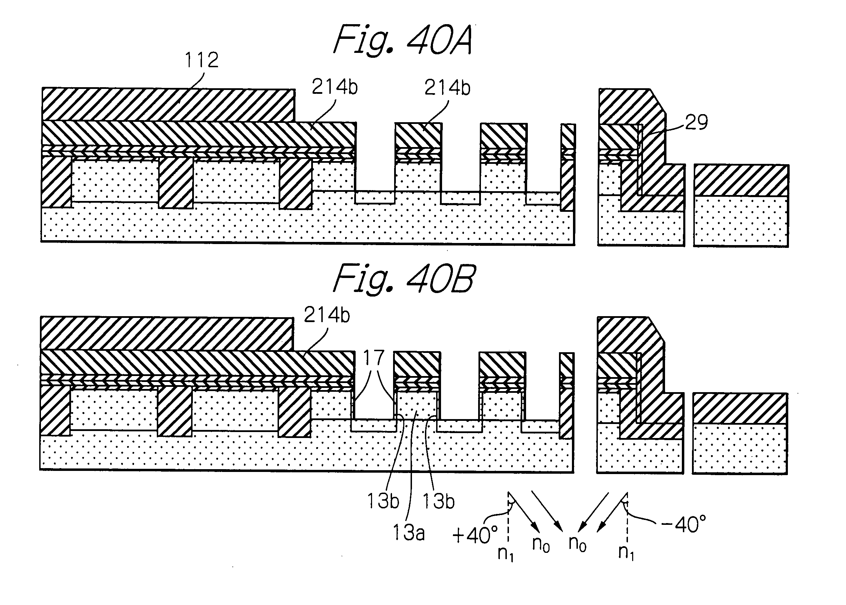

As shown in fig. 40A, after the above ion implantation, the silicon oxide layers 29 left on the sides 13b of the projections 13a are removed by etching using d-HF.

As shown in FIG. 40B, arsenic ions are implanted in the side walls 13b to thereby form N type regions 17 of counter conductivity type. Again, to implant arsenic ions in the side walls 13b, the substrate 12 should only be inclined relative to the direction of ion implantation. In the illustrative embodiment, the line n₁ normal to the P type silicon substrate 12 is inclined by about ±40° relative to the direction of ion implantation no. More specifically, arsenic ions are implanted with acceleration energy of 15 keV in a dose of 2.0 x 10¹² cm-².

As shown in FIG. 41A, after the photoresist 112 has been removed, about 8 nm thick, tunnel insulation layers or thermal oxide layers 15a are formed on the bottoms and sides of the trenches 28. At this instant, desirable oxide layers are formed at the bottom corners of the trenches 28 as well because the bottom corners have been rounded in the step of FIG. 38A. The tunnel insulation layers 15a have critical influence on device operation and should therefore preferably be provided with desirable property. Although the oxide layers on the surfaces of plane direction (100) are thinner than the oxide layers on the surfaces of plane direction (111), such a difference in thickness does not adversely effect the S type memory.

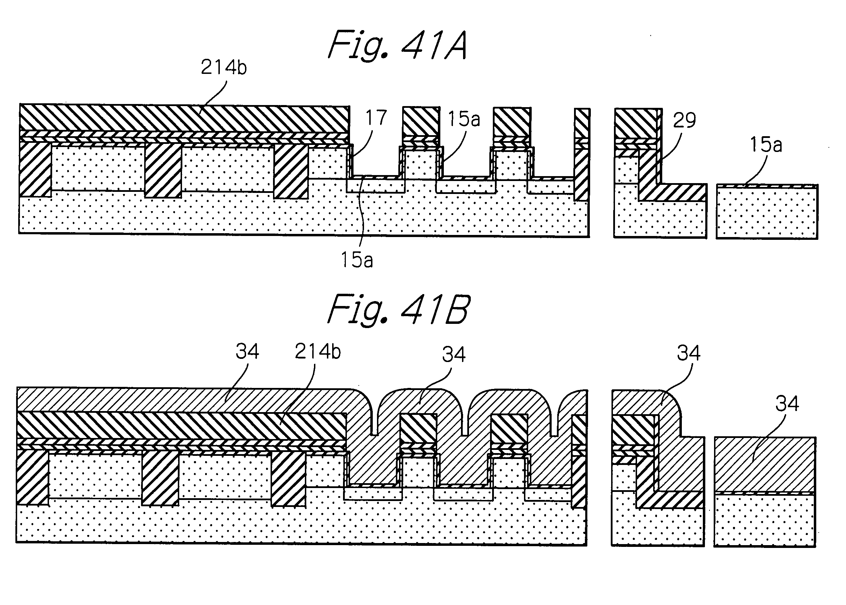

As shown in FIG. 41B, after the step of FIG. 41A, an about 100 nm thick, polycrystalline silicon layer or conductive layer 34 is formed on the tunnel insulation layers 15a. The polycrystalline silicon layer 34 is doped with phosphor (P) beforehand by an in-situ process.

Subsequently, as shown in FIG. 42A, the polycrystalline silicone layer 34 is anisotropically etched to a depth of 120 nm in the direction of thickness by use of Cl₂/HBr gas. Selectivity of this etching is at least:
polycrystalline silicon : silicon nitride layer = 20 : 1
polycrystalline silicon : silicon oxide layer = 70 : 1
although actual selectivity is far greater than the above selectively.

More specifically, the polycrystalline silicon layer 34 is etched such that it disappears on the silicon nitride layers 214b, but remains on the tunnel insulation layers 15a on the sides of the trenches 28. As a result, two polycrystalline silicon layers adjacent to each other are isolated from each other.

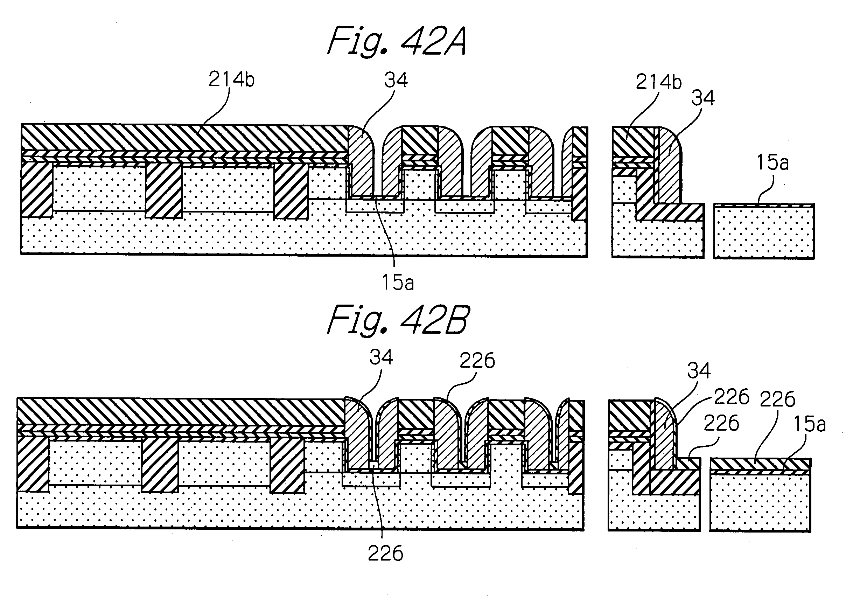

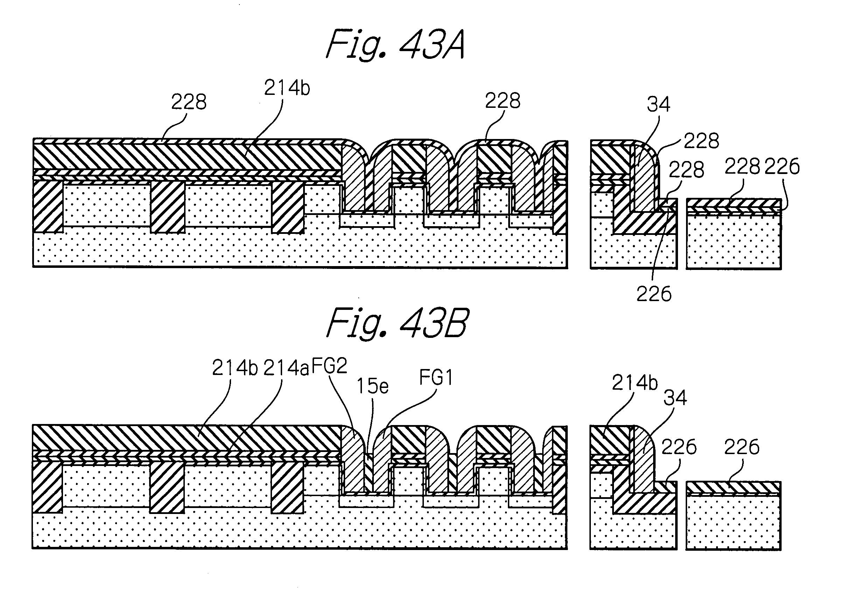

Subsequently, as shown in FIG. 42B, thermal oxidation is effected to form 10 nm thick, thermal oxide layers 226 on the polycrystalline silicon layers 34 and tunnel insulation layers 15a. Thereafter, as shown in FIG. 43A, 25 nm thick, silicon oxide layers 228 are formed on the thermal oxide layers 226. Consequently, an insulator is filled in the gap between nearby polycrystalline silicon layers 34 to thereby electrically isolate them from each other.

As shown in FIG. 43B, after the step of FIG. 43A, the oxide layers 228 are etched by SAC (Self-Align Contact) oxide film RIE using C₄F₈/O₂/Ar gas. Selectivity of this etching is:
silicone oxide layer : silicon nitride layer = 25 : 1
silicon oxide layer : polycrystalline silicon = 50 : 1

The oxide layers 15e between the floating gates FG1 and FG2 are also etched to the same height as the sacrifice oxide layers 214a.

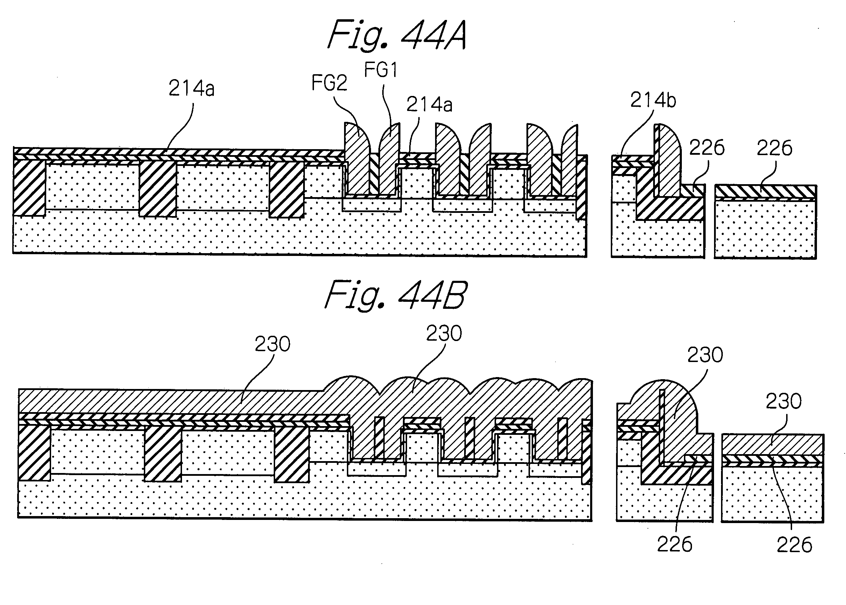

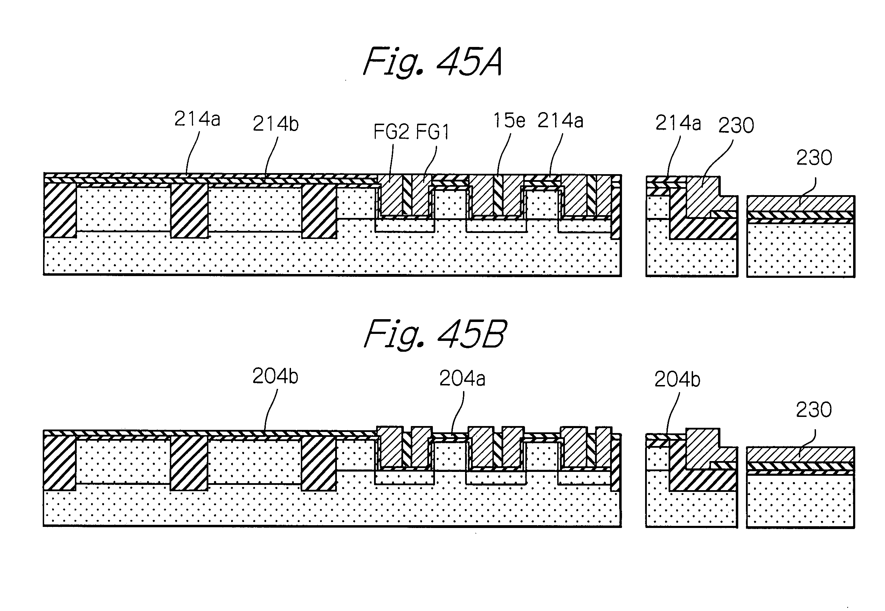

As shown in FIG. 44A, the silicon oxide layers 214b are removed by etching with H₃PO₄. Subsequently, as shown in FIG. 44B, a polycrystalline silicon layer 230 is formed on the entire surface of the laminate by CVD. The polycrystalline silicone layer 230 is then flattened by CMP, as shown in FIG. 45A. At this instant, selectivity is at least:
polycrystalline silicon : silicon oxide layer = 50 : 1

Slurry may be implemented by organic amine, e.g., NH₂(CH₂)₂NH₂ by way of example. To rinse the surface of the polycrystalline silicone layer 230, use may be made of e.g., APM, i.e., NH₄OH, H₂O₂ or FPM, i.e., HP, H₂O₂. This step successfully executes CMP with the floating gate surfaces expected to contact inter-polycrystalline insulation layers later andmakes the surface of the polycrystalline silicon layer 230 extremely smooth and clean.

Subsequently, as shown in FIG. 45B, the silicon oxide layers 214a are removed by etching using d-HF gas because the layers 214a have been noticeably damaged. The etching is effected such that the tops of the floating gates FG1 and FG2 on the side walls of the trenches 28 are positioned at a higher level than the tops of the projections 13a, thereby fully configuring the floating gates FG1 and FG2.

Now, attention shouldbe paid to the role that the silicon nitride layers 214b and silicon oxide layers 214a have played up to the step stated above. The silicon nitride layers 214b and silicon oxide layers 214a are formed on the gate insulation layers 204b in the step of FIG. 37A and continuously cover the gate insulation layers 204b up to the step of FIG. 45A. The gate insulation layers 204b, having critical influence on device operation, are therefore protected from deterioration throughout various processes including ion implantation, etching and formation of different kinds of layers, so that device operation characteristics are protected from deterioration.

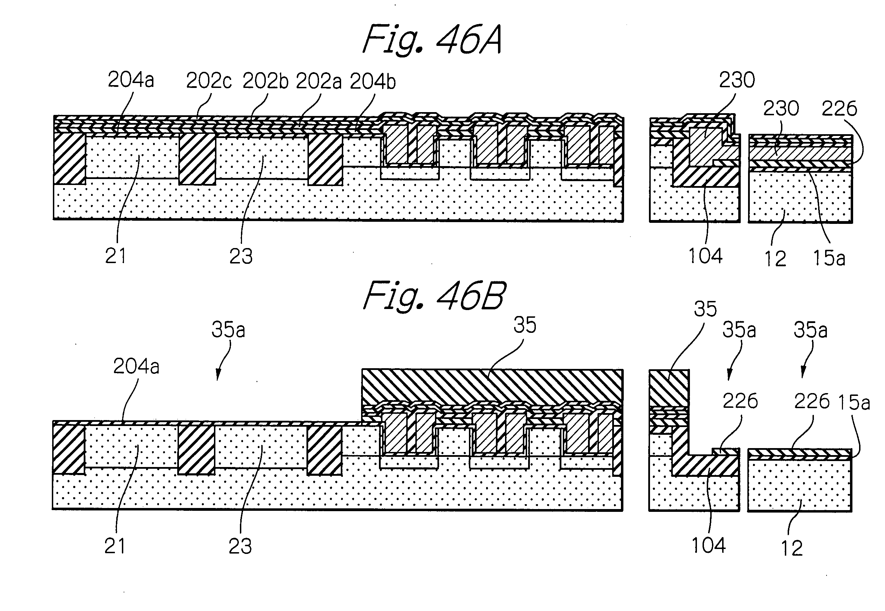

As shown in FIG. 46A, after the step of FIG. 45B, an about 5 nm thick oxide layer 202a, an about 7 nm thick nitride layer 202b and an about 5 nm thick oxide layer 202c are sequentially stacked in this order, forming about 17 nm thick, gate insulation layers 15b. At this instant, the gate insulation layers or inter-polycrystalline insulation layers 15b contact the surfaces of the floating gates FG1 and FG2 flattened by CMP beforehand and therefore have high breakdown voltage. To further enhance breakdown voltage, the corners of the floating gates FG1 and FG2 may be rounded before the formation of the gate insulation layers 15b, if desired.

Subsequently, as shown in FIG. 46B, a photoresist layer 35 is coated on the entire surface of the laminate and then exposed and developed to form recesses 35a in the MOS transistor portion CM, device isolation region STIb and bank select transistor STO or STE. The gate insulation layer 15b and silicon nitride layer 204b in the CMOS transistor portion CM are removed by etching with the photoresist layer 35 serving as a mask. Also, the gate insulation layer 15b in the device isolation region STIb and bank select transistor STO or STE is removed by etching.

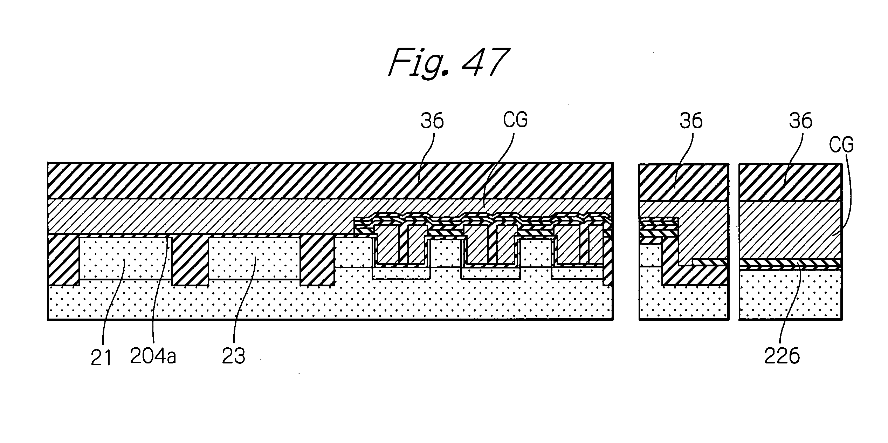

As shown in FIG. 47, after the photoresist layer 35 has been removed, a polycrystalline silicon layer CG is formed by CVD and then has its surface polished by CMP and flattened thereby. After a WSi layer has been formed, a silicon oxide layer 36 is formed on the WSi layer. In FIG. 47, the polycrystalline silicon layer and CG and WSi layers overlying it are collectively labeled CG. By the step of FIG. 47, a plurality of control gates CG, each extending in the direction of row, are formed. At the same time, gate electrodes 41 are formed on the P type well 23 and N type well 21 of the CMOS transistor portion. The gate electrodes 41 are mainly constituted by the polycrystalline silicone layer and lowered in resistance by the WSi layer. The WSi layer is formed on the control gate CG also and therefore lowers the resistance of the control gate CG as well.

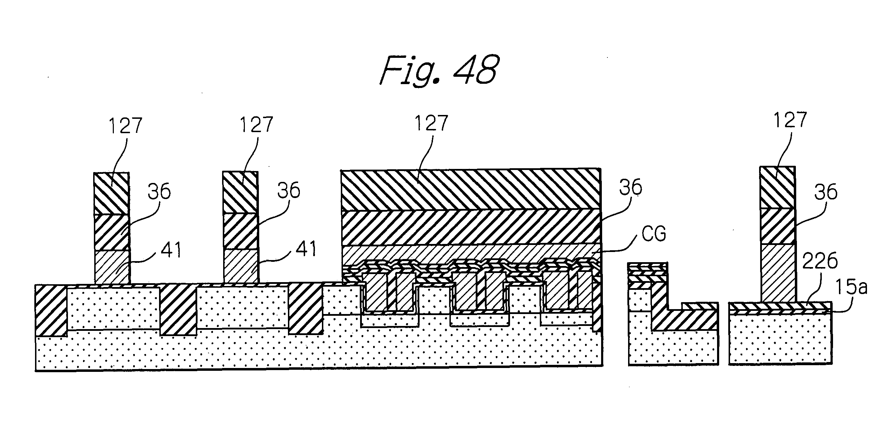

As shown in FIG. 48, after a photoresist layer 127 has been coated and then exposed and developed in a preselected pattern, the silicon oxide layer 36 is patterned with the patterned photoresist layer 127 serving as a mask. Subsequently, the polycrystalline silicon layer CG is patterned with the patterned silicon oxide layer 36 serving as a mask. As shown in the figure, the polycrystalline silicon layer or control gate CG is removed in portions 129a assigned to the source/drain regions of the CMOS transistor portion CM, a portion 129b assigned to the device isolation region STIb of the cell transistor portion CT, which extends in the direction of column, a portion 129c assigned to the source/drain region of the bank select transistor STO or STE, and the region, FIG. 1, between the control gates CG each extending in the direction of row.

After the step of FIG. 48, the device isolation region STIb, an N type and a P type MOS transistor 123 and 124 corresponding to the CMOS transistor portion CM and bank select transistor STO or STE are formed by the steps described with reference to FIGS. 32A through 35, completing the S type transistor shown in FIG. 14.

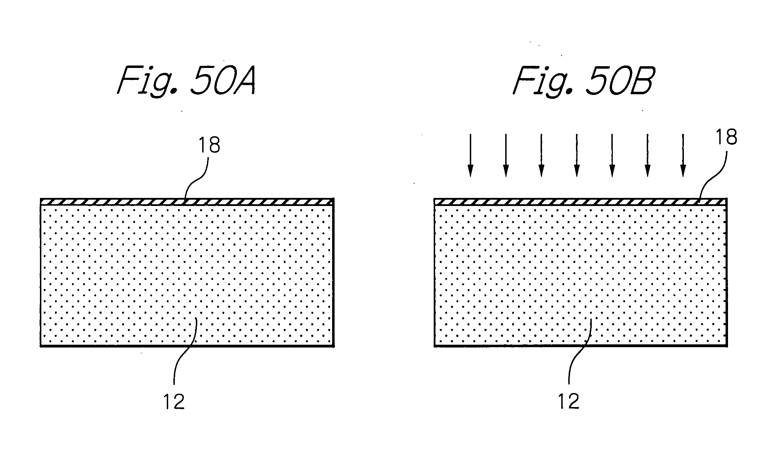

A specific procedure for producing the L type memory shown in FIG. 15 will be described with reference to FIGS. 50A through 62 hereinafter. In this case, too, processes for producing a cell transistor can be executed at the same time as processes for producing a CMOS transistor. Such processes are identical with the previously stated processes and will not be described specifically in order to avoid redundancy. The device isolation region STIb and bank select transistor STO or STE are also formed by the steps stated earlier and will not be described specifically either. FIGS. 50A through 62 are sections showing only the cell transistor portion TC.

The initial stage of L type memory fabrication is identical with the stage described with reference to FIGS. 16A through 19B and will not be described specifically. As shown in FIG. 50A, the silicon oxide layer 18 formed in the steps of FIGS. 16A through 19B exists on the semiconductor substrate 12.

In the above condition, as shown in FIG. 50B, BF₂ ions and boron ions are implanted over the silicon oxide layer 18 independently of each other to thereby form a P⁻ type layer and a P⁺ type layer at a shallow position and a deep position, respectively. At this instant, boron ions are implanted to a deep position thee times while BF₂ ions are implanted to a shallow position two times. More specifically, boron ions are first implanted with acceleration energy of 30 keV in a dose of 4.0 x 10¹¹ cm⁻², then implanted with acceleration energy of 35 keV in a dose of 4.0 x 10¹² cm⁻², and then implanted with acceleration energy of 55 keV in a dose of 4.0 x 10¹² cm⁻². BF₂ ions are first implanted with acceleration energy of 15 keV in a dose of 2.0 x 10¹¹ cm⁻² and then implanted with acceleration energy of 45 keV in a dose of 2.0 x 10¹¹ cm⁻². The P⁻ type layer forms the channel of the transistor while the P⁺ type layer serves to protect the cell transistor from punch-through.

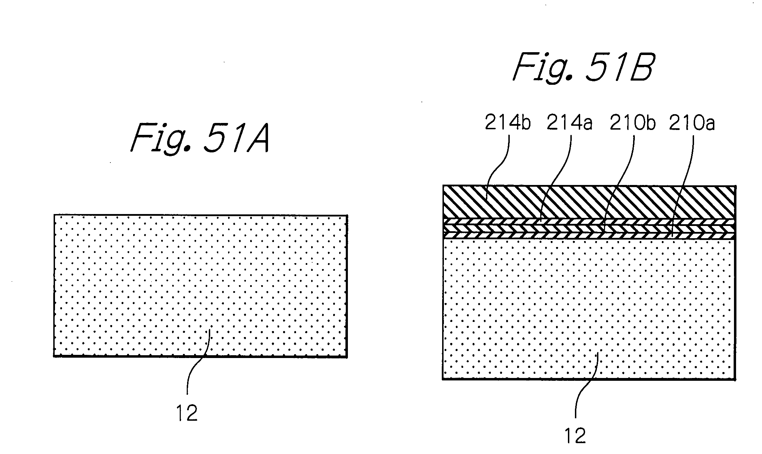

As shown in FIG. 51A, the silicon oxide layer 18 is removed by etching using d-HF. Subsequently, as shown in FIG. 51B, an about 10 nm thick, gate insulation layer 210a, which is a silicon oxide layer, an about 20 nm thick, gate insulation layer 210b, which is a silicon nitride layer, an about 10 nm thick, silicon oxide layer 214a and an about 70 nm thick, silicon nitride layer 214b are sequentially stacked on the substrate 12 in this order. Such layers all are formed by CVD. The gate insulation layers 204a and 204b form part of the L type memory. The silicon oxide layer 214a serves as a sacrifice oxide layer while the silicon nitride layer 214b serves as a stopper when arsenic ions are implanted later.

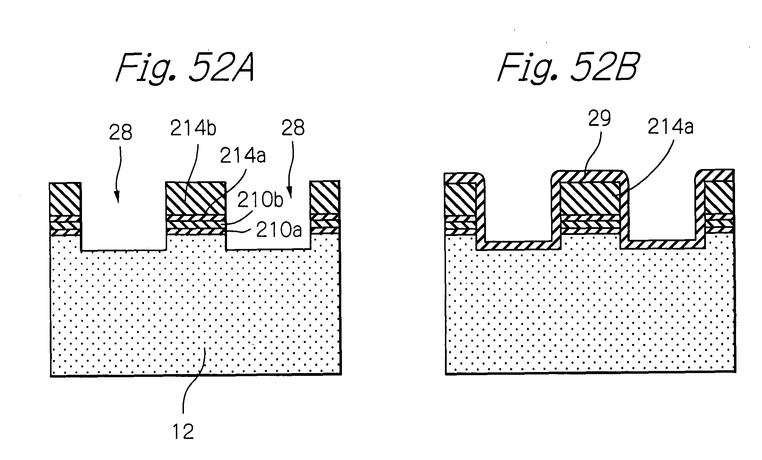

As shown in FIG. 52A, after the step of FIG. 51B, a photoresist, not shown, is coated on the silicon nitride layer 214b on the top of the laminate and then exposed and developed to form stripe-like openings not shown. Subsequently, the silicon nitride layer 214b, silicon oxide layer 214a, gate insulation layers 210b and 210a and silicon substrate 12 are etched by RIE via the above openings serving a mask. Subsequently, trenches 28 are formed in the P⁻ and P⁺ type layers, which are silicon layers, by RIE. The trenches 28 correspond in position to the source/drain regions BL1 and BL2 of the cell transistor TC. While the size of each trench 28 in the source/drain region BL1, BL2 or BL3 is open to choice, it is, in the illustrative embodiment, about 40 nmdeep that corresponds to the peak position of the concentration of boron ions implanted in the step of FIG. 50. Also, the distance between nearby trenches 28, i.e., the width of each projection 13a is about 180 nm. Each trench 28 is about 180 nm wide.

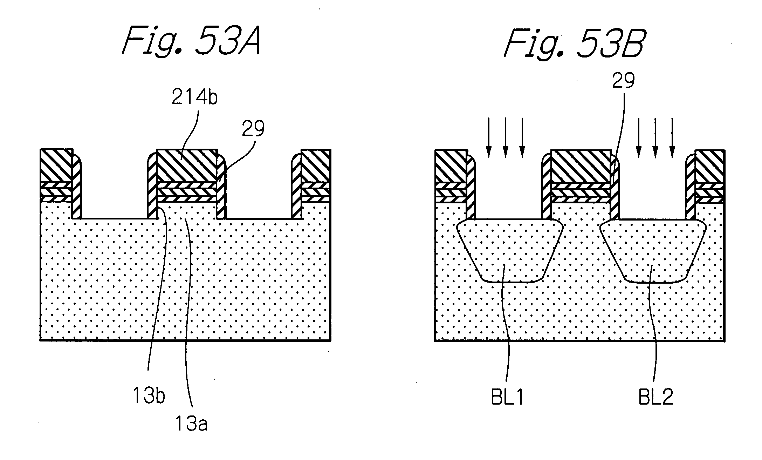

As shown in FIG. 52B, after the step of FIG. 51A, an about 25 nm thick, silicon oxide layer 29 is formed on the entire exposed surface of the laminate by CVD. Subsequently, as shown in FIG. 53A, the silicon oxide layer 29 is etched by RIE in the direction of thickness with the result that the silicon oxide layer 29 is removed except for its portions covering the side walls 13b of the projections 13a.

Subsequently, as shown in FIG. 53B, arsenic ions are implanted two times to thereby form N⁺ type layers, which constitute the bit lines BL1, BL2 and so forth, on the bottoms of the trenches 28. More specifically, arsenic ions are implanted with acceleration energy of 15 keV in a dose of 3.0 x 10¹⁵ cm⁻² and then implanted with acceleration energy of 40 keV in a dose of 3.0 x 10¹⁵ cm⁻². At this instant, the silicon oxide layers 29 left on the side walls 13b of the projection 13a prevent arsenic ions from being implanted in the side walls 13b. Further, the projections 13a, serving as a mask, allow the bit lines BL1, BL2 and so forth to be formed on the bottoms of the trenches 28 by self-alignment.

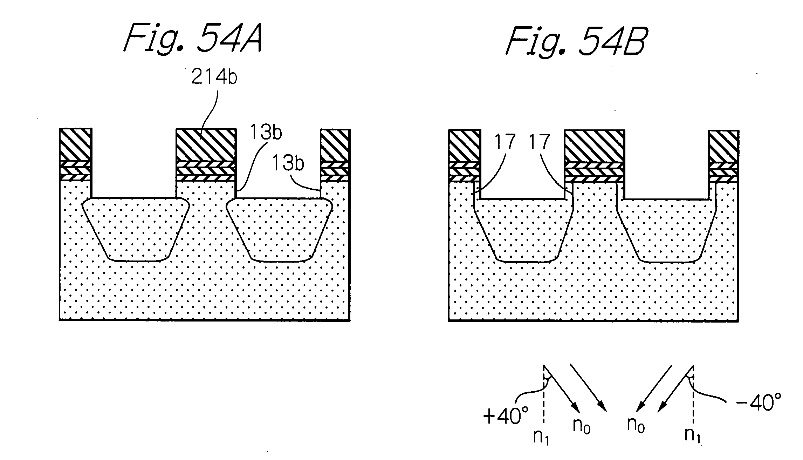

As shown in FIG. 54A, after the above ion implantation, the silicon oxide layers 29 left on the sides 13b of the projections 13a are removed by etching using d-HF.

As shown in FIG. 54B, after the step of FIG. 54A, arsenic ions are implanted in the side walls 13b with acceleration energy of 15 keV in a dose of 2.0 x 10¹² cm⁻² to thereby form N type regions or depletion layers 17 of counter conductivity type. Again, to implant arsenic ions in the side walls 13b, the substrate 12 should only be inclined relative to the direction of ion implantation. In the illustrative embodiment, the line n₁ normal to the P type silicon substrate 12 is inclined by about ±40° relative to the direction of ion implantation no.

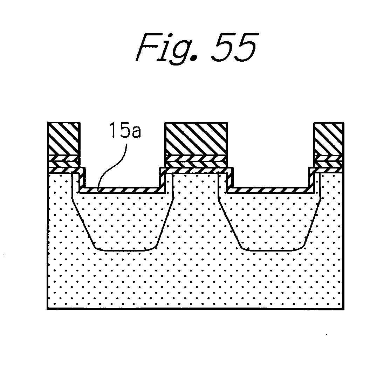

As shown in FIG. 55, after the step of FIG. 54B, about 8 nm thick, tunnel insulation layers or plasma oxide layers 15a and are formed on the bottoms and sides of the trenches 28. The tunnel insulation layers should preferably be provided with desirable property because they have critical influence on the device operation. To form the plasma oxide layers 15a, use may be made of the microwave excited, high density plasma device using a radial line slot antenna.

In the plasma device mentioned above, a Kr and O₂ mixture gas is introduced into the device. Krypton is excited by a microwave issuing from the radial line slot antenna and hits against O₂ for thereby generating a great amount of atomic state oxygen O^{*}. The atomic state oxygen O^{*} easily enters the surface layers of the trenches 28 and oxidizes the bottoms and sides of the trenches 28 at substantially the same rate without regard to the plane direction. For example, oxide layers with the plane direction (100) and those with the plane direction (111) have substantially the same thickness. After the oxide layers have been formed, the feed of the mixture gas and the emission of the microwave are stopped, and then the device is exhausted. The oxide layers thus formed by plasma oxidation implement a large Q_{BD} value and a small SILC ratio.

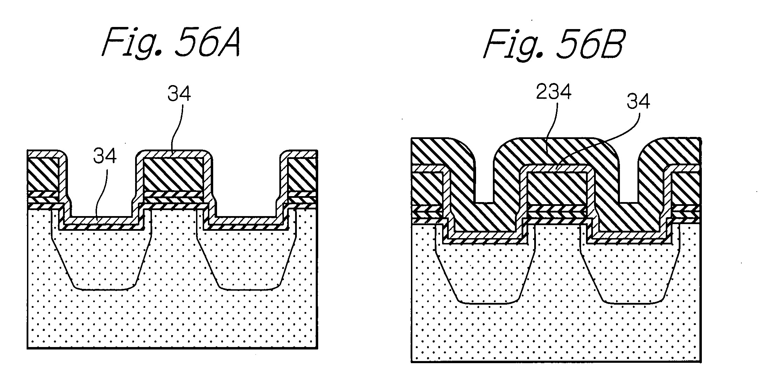

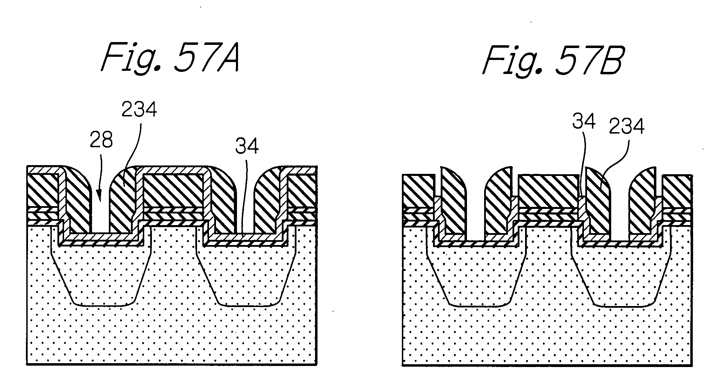

As shown in FIG. 56A, after the step of FIG. 55, an about 20 nm thick, polycrystalline silicon layer or conductive layer 34 is formed on the tunnel insulation layers 15a. The polycrystalline silicon layer 34 is doped with phosphor (P) by an in-situ process beforehand. Subsequently, as shown in FIG. 56B, a silicon nitride layer 234 is formed on the polycrystalline silicon layer 34. The silicon nitride layer 234 is then etched by RIE to thereby expose the center portions of the polycrystalline silicon layers 34 present on the bottoms of the trenches 28, as shown in FIG. 57A. Thereafter, as shown in FIG. 57B, the portions of the polycrystalline silicon layers 34 thus exposed are etched and removed by RIE.

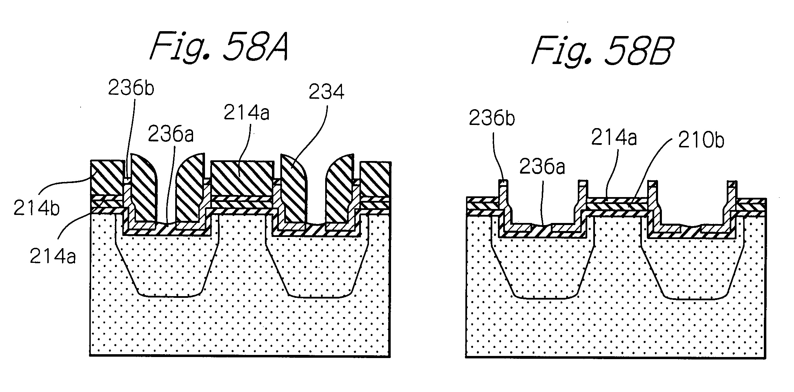

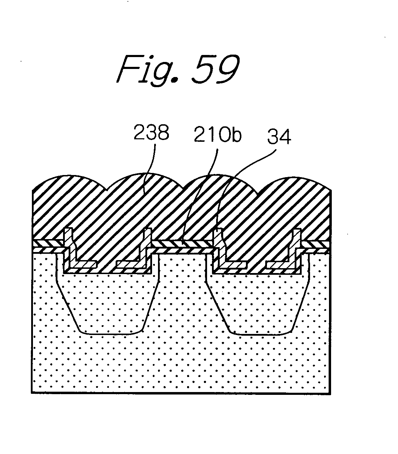

As shown in FIG. 58A, silicon oxide layers 236a and 236b are formed on the exposed portions of the polycrystalline silicon layers 34. Subsequently, as shown in FIG. 58B, the silicon nitride layers 214a and 234 are removed by etching. Thereafter, as shown in FIG. 59, a silicon oxide layer 238 is formed by CVD to thereby fill the gap between the polycrystalline silicon layers 34 with an insulation layer, thereby electrically isolating the polycrystalline silicon layers 34 adjoining each other.

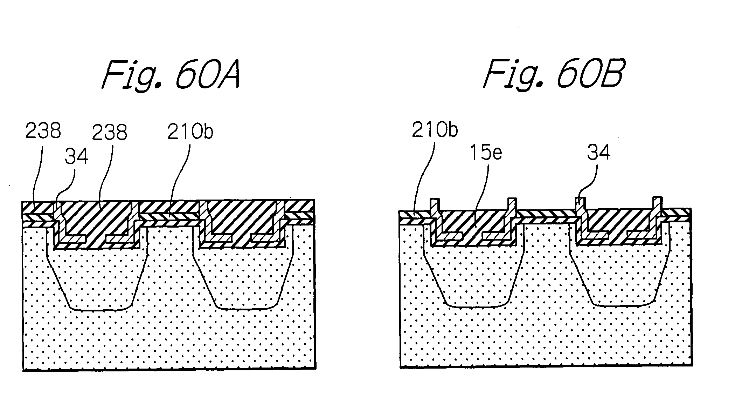

As shown in FIG. 60A, after the formation of the silicon oxide layer 238, the silicon oxide layer 238 has its excess part removed by CMP to such a degree that the tops of the polycrystalline silicon layers 34 are exposed. The surface of the silicon oxide layer 238 is then flattened. Subsequently, as shown in FIG. 60B, the silicon oxide layer 238 is etched by SAC oxide film RIE to such a depth that the silicon nitride layers 210b are exposed.

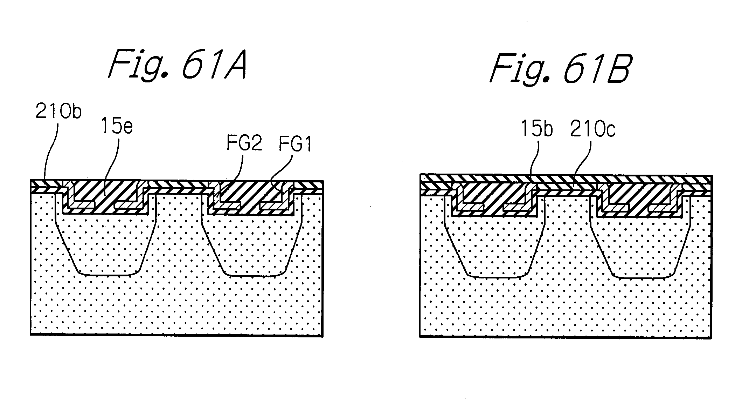

As shown in FIG. 61A, after the step of FIG. 60B, the polycrystalline silicon layers 34 are removed by CMP, and then the top of the laminate is flattened. At this instant, selectivity of CMP is at least:
polycrystalline silicon : silicon nitride layer = 100 : 1

Slurry may be implemented by organic amine, e.g., NH₂(CH₂)₂NH₂ by way of example. To rinse the surface of the polycrystalline silicone layer, use may be made of e.g. , APM, i.e., NH₄OH, H₂O₂ or FPM, i.e., HP, H₂O₂. This step successfully executes CMP with the floating gate surfaces expected to contact inter-polycrystalline insulation layers later and makes the surface of the polycrystalline silicon layer extremely smooth and clean. In this manner, the floating gates FG1 and FG2 are formed.

Subsequently, as shown in FIG. 61B, an about 12 nm thick oxide layer 210c is formed on the entire bare surface of the laminate and then subjected to plasma oxidation, so that the oxide layers 210c formed by CVD are made dense. At this instant, the gate insulation layers or inter-polycrystalline insulation layers 15b present on the floating gates FG1 and FG2 contact the surfaces of the floating gates flattened by CMP in the step of FIG. 61A and therefore realize high breakdown voltage. To further improve breakdown voltage, the corners of the floating gates FG1 and FG2 may be rounded before the formation of the gate insulation layers 15b, if desired.

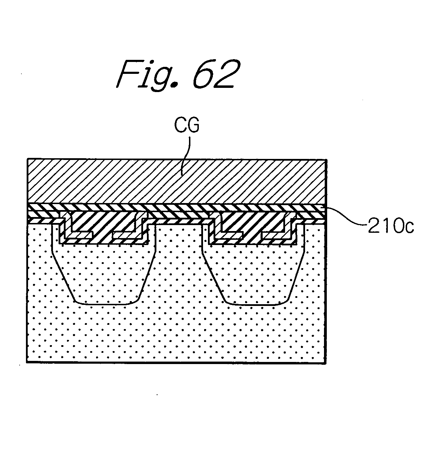

Finally, as shown in FIG. 62, a polycrystalline silicon layer CG is formed on the oxide layer 210c by CVD and then has its surface polished by CMP to be flattened thereby, forming a WSi layer. Subsequently, a silicon oxide layer, not shown, is formed on the polycrystalline silicon layer CG. The polycrystalline silicon layer CG and WSi layer overlying it are collectively labeled CG. Consequently, a plurality of control gates CG, each extending in the direction of row, are formed, completing the L type memory.

While in the illustrative embodiments P type and N type are respectively used as one-conductivity type and counter-conductivity type, N type and P type may, of course, be used as one-conductivity type and counter-conductivity type, respectively.

In the S type memory including substantially square floating gates FG1 and FG2, each inter-polycrystalline silicon layer 15b is made up of the silicon oxide layer 202a, silicon nitride layer 202b and silicon oxide layer 202c sequentially stacked in this order while each tunnel insulation layer 15a is implemented by the silicon oxide layer 204a. In this condition, assume first capacitance between the floating gates FG1 and FG2 and the control gate CG facing each other via the inter-polycrystalline insulation layers 15b and second capacitance between the floating gates FG1 and FG2 and the side walls 13b of the projection 13a and source/drain regions BL1 and BL2 facing each other via the tunnel insulation layers 15a. Then, the ratio of the first capacity to the second capacity should preferably be 0.35 or less.

Further, assume the cell transistor TC in which the surface of each floating gate FG1 or FG2, facing the control gate CG via the inter-polycrystalline insulation layer 15b, has an area smaller than the area of another surface facing the source/drain region BL1 or BL2 via the tunnel insulation layer 15a as in the L type memory. Then, the inter-polycrystalline insulation layer 15b and tunnel insulation layer 15a may be implemented as silicon oxide layers formed by plasma oxidation. In this case, the ratio of the first capacity to the second capacity mentioned above should preferably be 0.20 or less.

In the illustrative embodiments, part of each floating gate FG1 or FG2 protrudes above the top 13c of the projection 13a and does not cover the top 13c. In this configuration, a carrier, running in the vicinity of the top 13c in a write mode, can be efficiently injected into and captured by the floating gate FG1 or FG2. In addition, the control gate CG can surely control the channel region adjacent to the top 13c.

In the illustrative embodiments, a plurality of cell transistors TC are arranged in the direction connecting the source/drain regions BL1 and BL2. The fourth insulation layer. 15f intervenes between the floating gate FG1 or FG2 of one of nearby cell transistors and the floating ate FG2 or FG1 of the other cell transistor, electrically isolating the control gate CG and source/drain regions BL1 and BL2. This successfully reduces leak current to flow between the control gate CG and the source/drain regions BL1 and BL2.

As for the S type or the L type memory, by flattening the surfaces of the floating gates FG1 and FG2 facing the control gate CG and then forming the inter-polycrystalline insulation layers 15b, it is possible to provide the insulation layers 15b with desirable property for thereby enhancing breakdown voltage.

In summary, it has been or will be seen that the present invention provides a transistor, a semiconductor memory using the same and a method of manufacturing a transistor having the following various unprecedented advantages.

A channel is not formed in a region linearly connecting source/drain regions, but is formed bidimensionally in a region constituted by one side wall, top and the other side wall of a projection. Therefore, the side walls of the proj ection face floating gates, so that the floating gates are positioned in the direction in which a carrier flows along the top of the projection. It follows that in a write mode, the carrier can be inj ected into the floatinggate straightforward without being steered at all. This lowers a voltage necessary for accelerating the carrier and thereby makes a write voltage lower than conventional one.

On the other hand, in a read mode, a read voltage is applied to a control gate while a preselected potential difference is established between the source/drain regions. The floating gates each are capacity-coupled with one of the source/drain regions via a second insulation layer. In this condition, assuming that the read voltage is a positive voltage and that the floating gate corresponds to one source/drain region higher in potential than the other source/drain region, then the potential of the floating gate is attracted toward the positive potential side by capacity coupling with the source/drain region as well. Consequently, when electrons, for example, are absent in the above floating gate as a carrier, the source/drain voltage increases a channel current around the floating gate. Even when electrons are present in the floating gate, the potential of the floating gate is prevented from being lowered by the electrons, so that a relatively broad channel is available around the floating gate. It follows that a drain current Id₁ can be increased to a desired degree.

When the potential difference between the source/drain regions is inverted, the floating gate concerned faces the source/drain region positioned at the low potential side. At the same time, the floating gate is capacity-coupled with the control gate by a third insulation layer as well. As a result, if electrons are absent in the floating gate, then the floating gate is slightly raised to a positive potential by a gate voltage V_{G} via the third insulation layer, guaranteeing a channel around the floating gate and a desired drain current Id₂. On the other hand, when electrons are present in the floating gate, the above potential of the floating gate is lowered with the result that channel resistance around the floating gate increases to reduce the drain current Id₂ to a desired value. The present invention therefore allows the current window, i.e., the difference between the drain current Id₁ and the drain current Id₂, which flows when electrons are present in the floating gate, to be increased, as desired.

Moreover, electrons exist in two floating gates independently of each other. Therefore, when a cell transistor is reduced in size, the floating gate in which electrons exist can be clearly distinguished from the other floating gate.

The entire disclosure of Japanese patent application No. 2003-001189 filed on January 7, 2003 including the specification, claims, accompanying drawings and abstract of the disclosure is incorporated herein by reference in its entirety.

While the present invention has been described with reference to the particular illustrative embodiments, it is not to be restricted by the embodiments. It is to be appreciated that those skilled in the art can change or modify the embodiments without departing from the scope and spirit of the present invention.

## Claims

1. A transistor
**CHARACTERIZED BY** comprising:
a one-conductivity type semiconductor substrate (13) formed with a proj ection (13a) having a pair of side walls (13b) facing each other;
a first insulation layer (15c) formed on a top (13c) of the projection (13a);
a pair of counter-conductivity type source/drain regions (BL1, BL2) formed on a surface of said semiconductor substrate (13) at both sides of the projection (13a);
second insulation layers (15a) each covering one of the pair of side walls (13b) and one of said source/drain regions (BL1, BL2);
a pair of floating gates (FG1, FG2) respectively formed on the pair of side walls (13b) of the projection (13a) and respectively facing the side walls (13b) and said source/drain regions (BL1, BL2) via respective second insulation layers (15a) ;
third insulation layers (15b) each being formed on one of said floating gates(FG1, FG2); and
a control gate (CG) facing said pair of floating gates (FG1, FG2) via said third insulation layers (15b) and facing the top (13c) of the projection (13a) via said first insulation layer (15c);
wherein said pair of floating gates (FG1, FG2) each have a substantially square section that faces one of the side walls (13b) of the projection (13a) via one of said second insulation layers (15a) at one side, faces one of said source/drain regions (BL1, BL2) via said one second insulation layer (15a) at another side, and faces said control gate (CG) via one of said third insulation layers (15b) at another side.

2. The transistor in accordance with claim 1,
**CHARACTERIZED IN THAT** said third insulation layers (15b) each comprise a silicon oxide layer, a silicon nitride layer and a silicon oxide layer sequentially stacked in this order, and said second insulation layers each comprise a silicon oxide layer.

3. The transistor in accordance with claim 1 or 2, **CHARACTERIZED IN THAT** a ratio of first capacitance between each of said floating gates (FG1, FG2) and said control gate (CG) , facing each other via one of said third insulation layers (15b) , to second capacitance between said floating gate (FG1, FG2) and the side wall (15b) of the projection (15a) and one of said source/drain regions (BL1, BL2) , facing each other via one of said second insulation layers (15a), is 0.35 or less.

4. A transistor
**CHARACTERIZED BY** comprising:
a one-conductivity type semiconductor substrate (13) formed with a projection (13a) having a pair of side walls (13b) facing each other;
a first insulation layer (15c) formed on a top (13c) of the projection (13a);
a pair of counter-conductivity type source/drain regions (BL1, BL2) formed on a surface of said semiconductor substrate (13) at both sides of the projection (13a) ;
second insulation layers (15a) each covering one of the pair of side walls (13b) and one of said source/drain regions (BL1, BL2);
a pair of floating gates (FG1, FG2) respectively formed on the pair of side walls (13b) of the projection (13a) and respectively facing the side walls (13b) and said source/drain regions (BL1, BL2) via respective second insulation layers (15a) ;
third insulation layers (15b) each being formed on one of said floating gates (FG1, FG2); and
a control gate (CG) facing said pair of floating gates (FG1, FG2) via said third insulation layers (15b) and facing the top (13c) of the projection (13a) via said first insulation layer (15c);
wherein a surface of each of said pair of floating gates (FG1, FG2), facing one of said pair of source/drain regions (BL1, BL2) via said control gate (CG) , has a smaller area than a surface of said floating gate (FG1, FG2) facing one of said pair of source/drain regions (BL1, BL2) via one of said second insulation layers (15a).

5. The transistor in accordance with claim 4,
**CHARACTERIZED IN THAT** said floating gates (FG1, FG2) each have a substantially L-shaped section that faces, at a vertical portion of a letter L, one of the side walls (13b) of the proj ection (13a) via one of said second insulation layers (15a) and faces, at a horizontal portion of the letter L, one of said source/drain regions (BL1, BL2) via said second insulation layer (15a).

6. The transistor in accordance with claim 4 or 5, **CHARACTERIZED IN THAT** said third insulation layers (15b) and said second insulation layers (15a) each comprise a silicon oxide layer formed by plasma oxidation.

7. The transistor in accordance with claim 4, 5 or 6, **CHARACTERIZED IN THAT** a ratio of first capacitance between each of said floating gates (FG1, FG2) and said control gate (CG) , facing each other via one of said third insulation layers (15b) , to second capacitance between said floating gate (FG1, FG2) and the side wall (13b) of the projection (13a) and one of said source/drain regions (BL1, BL2) , facing each other via one of said second insulation layers (15a), is 0.20 or less.

8. The transistor in accordance with any one of claims 1 through 7, **CHARACTERIZED IN THAT** each of said floating gates (FG1, FG2) does not cover the top (13c) of the proj ection (13a) .

9. The transistor in accordance with any one of claims 1 through 8, **CHARACTERIZED IN THAT** each of said floating gates (FG1, FG2) partly protrudes above the top (13c) of the proj ection (13a) .

10. The transistor in accordance with any one of claims 1 through 9, **CHARACTERIZED IN THAT** the surface of said floating gate (FG1, FG2), facing said control gate (CG) via said third insulation layer (15b) , is flattened by CMP (Chemical Mechanical Polishing).

11. The transistor in accordance with any one of claims 1 through 10, **CHARACTERIZED IN THAT** the transistor comprises a plurality of transistors arranged in a direction of column and a direction of row, constituting a semiconductor memory.

12. The transistor in accordance with claim 11, **CHARACTERIZED IN THAT** the transistors, adjoining each other in the direction of column, share said source/drain regions (BL1, BL2), and the transistors, adjoining each other in the direction of row, share said control gate (CG) and said source/drain regions (BL1, BL2) between said transistors.

13. The transistor in accordance with claim 11 or 12, **CHARACTERIZED IN THAT** the transistors are arranged in a direction connecting said source/drain regions (BL1, BL2) , and a fourth insulation layer (15f) is formed between said floating gate (FG1, FG2) of one of said transistors, adjoining each other, and said floating gate (FG1, FG2) of the other transistor to thereby electrically isolate said control gate (CG) and said source/drain regions (BL1, BL2).

14. A method of manufacturing a transistor,
**CHARACTERIZED BY** comprising the steps of:
(a) forming a plurality of trenches (28) in a primary surface of a one-conductivity type semiconductor substrate (13) to thereby form a plurality of projections (13a) each having a pair of side walls (13b) that face each other;
(b) implanting a counter-conductivity type impurity in bottoms of said plurality of trenches (28) to thereby form source/drain regions (BL1, BL2) on said bottoms;
(c) forming second insulation layers (15a) on said source/drain regions (BL1, BL2) and the side walls (13b) of each of said projections (13a);
(d) forming floating gates (FG1, FG2), each having a substantially square section, on the side walls (13b) of the projection (13a) and said source/drain regions (BL1, BL2) via said second insulation layers (15a);
(e) forming a fourth insulation layer (15f) between said floating gate (FG1, FG2) formed on one of the side walls (13b) of one of the projections (13a), which adjoin each other, and said floating gate (FG1, FG2) formed on the side wall (13b) of the other projection (13a); and
(f) forming third insulation layers (15b) on said fourth insulation layer (15f) and said floating gates (FG1, FG2) , and forming a control gate (CG) on said third insulation layers (15b).

15. The method in accordance with claim 14; **CHARACTERIZED IN THAT** step (f) comprises flattening surfaces of said floating gates (FG1, FG2), facing said control gate (CG), by CMP and then forming said third insulation layers (15b).

16. A method of manufacturing a semiconductor memory,
**CHARACTERIZED BY** comprising the steps of
(a) forming a plurality of trenches (28) in a primary surface of a one-conductivity type semiconductor substrate (13) to thereby form a plurality of projections (13a) each having a pair of side walls (13b) that face each other;
(b) implanting a counter-conductivity type impurity in bottoms of said plurality of trenches to thereby form source/drain regions (BL1, BL2) on said bottoms;
(c) forming second insulation layers (15a) on said source/drain regions (BL1, BL2) and the side walls (13b) of each of said projections (13a);
(d) forming floating gates (FG1, FG2), each having a substantially L-shaped section, on the side walls (13b) of the projection (13a) and said source/drain regions (BL1, BL2) via said second insulation layers (15a);
(e) forming a fourth insulation layer (15f) between said floating gate (FG1, FG2) formed on one of the side walls (13b) of one of the projections (13a) , which adjoin each other, and said floating gate (FG1, FG2) formed on the side wall (13b) of the other projection (13a); and
(f) forming third insulation layers (15b) on said fourth insulation layer (15f) and said floating gates (FG1, FG2) , and forming a control gate (CG) on said third insulation layers (15b).

17. The method in accordance with claim 16, **CHARACTERIZED IN THAT** step (f) comprises flattening surfaces of said floating gates (FG1, FG2) and a surface of said fourth insulation layer (15f) , facing said control gate (CG) , by CMP and then forming said third insulation layers (15b).

18. A semiconductor device
**CHARACTERIZED BY** comprising:
a one-conductivity type semiconductor substrate (13);
a first insulation layer (15a) formed on said semiconductor substrate (13);
a first electrode (FG1, FG2) formed via said first insulation layer (15a) by use of a semiconductor;
a second insulation layer (15b) formed on said first electrode; and
a second electrode formed on said first electrode via said second insulation layer (15b) by use of a semiconductor;
a surface of said first electrode, facing said second electrode via said second insulation layer (15b) , is flattened by CMP.
